# EUROPEAN PATENT APPLICATION

(11) **EP 4 576 208 A1**
(43) Date of publication of application: **25.06.2025**
(21) Application number: 24213236.3
(22) Date of filing: 15.11.2024
(51) Int. Cl.: H01L 23/522, H01L 23/48, H01L 21/768, H01L 23/538, H10D 1/00, H10D 1/68

(54) **CAPACITORS INTEGRATED WITH VIA STRUCTURES**

(30) Priority: 18.12.2023 US 202318543241
(71) Applicant: Intel Corporation, Santa Clara, CA 95054 (US)
(72) Inventor: FROST, Denzil S., Rio Rancho, NM 87124 (US); PARK, Changyok, Portland, OR 97229 (US); WANG, Peihua, Hillsboro, OR 97006 (US)
(74) Representative: HGF

(57) **Abstract**

Techniques are provided herein for forming one or more MIM capacitors either around or integrated in via structures. The via structures may be through-semiconductor via (TSV) structures that extend through a relatively thick portion of a semiconductor substrate, or may be nano-scale via structures that extend through a given device layer of a die. In an example, the capacitor is formed along the outside of a TSV and extends along an entire height of the TSV such that the TSV directly contacts a first electrode of the capacitor. In another example, a capacitor is formed in-line with a portion of a nano-scale via such that a first electrode of the capacitor directly contacts the top surface of portion of the via. In another example, a capacitor is formed directly adjacent to a nano-scale via such that a first electrode of the capacitor directly contacts a sidewall of the via.

## Description

### BACKGROUND

As integrated circuits continue to scale downward in size, a number of challenges arise. As density of devices increases, the available space on a given die dwindles rapidly. Some structures require a certain amount of space to operate effectively, but the limited available footprint on a die makes arranging these structures challenging. Accordingly, there remain a number of non-trivial challenges with respect to fabricating certain structures in an integrated circuit.

### BRIEF DESCRIPTION OF THE DRAWINGS

Figure 1 is a cross-sectional view that illustrates an example portion of an integrated circuit configured with an interconnect region over a plurality of semiconductor devices, in accordance with an embodiment of the present disclosure.
Figure 2 is a cross-sectional view of a metal-insulator-metal (MIM) capacitor around a pair of trough-silicon vias (TSVs), in accordance with a first embodiment of the present disclosure.
Figure 3 is a cross-sectional view of a MIM capacitor provided in line with a nano-scale via, in accordance with a second embodiment of the present disclosure.
Figure 4 is a cross-sectional view of a MIM capacitor provided adjacent to a nano-scale via, in accordance with a second embodiment of the present disclosure.
Figures 5A - 5J illustrate cross-sectional views of a first process for forming the MIM capacitor around a pair of TSVs, in accordance with some embodiments of the present disclosure.
Figures 6A - 6J illustrate cross-sectional views of a second process for forming MIM capacitors provided in line with nano-scale vias, in accordance with some embodiments of the present disclosure.
Figures 7A - 7J illustrate cross-sectional views of a third process for forming MIM capacitors provided adjacent to nano-scale vias, in accordance with some embodiments of the present disclosure.
Figure 8 illustrates a cross-section view of a chip package containing one or more semiconductor dies, in accordance with an embodiment of the present disclosure.
Figure 9 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein for forming one or more MIM capacitors either around or integrated in via structures. The via structures may be TSV structures that extend through a relatively thick substrate (e.g., at least 10 µm deep), or may be nano-scale via structures that extend through the device layer of a die (e.g., less than 1000 nm or less than 500 nm deep). Although the techniques can be used in any number of integrated circuit applications, they are particularly useful with respect to forming metal-insulator-metal (MIM) devices. In a first example, the MIM capacitor is formed along the outside of a TSV such that the TSV directly contacts a first electrode of the capacitor while the capacitor dielectric layer and second electrode extend along the height of the TSV. A front-side contact may be formed to provide electrical contact with the second electrode while a backside contact couples to the TSV to provide electrical contact to the first electrode. In a second example, a MIM capacitor is formed in-line with a portion of a nano-scale via such that a first electrode of the MIM capacitor directly contacts the top surface of a conductive plug at the bottom of a via recess. The capacitor dielectric is formed over the first electrode and the second electrode is formed on the capacitor dielectric within a remaining volume of the via recess. In a third example, a MIM capacitor is formed directly adjacent to a nano-scale via such that a first electrode of the MIM capacitor directly contacts a sidewall of the nano-scale via as part of a capacitor cavity. The capacitor dielectric is formed over the first electrode within the capacitor cavity and the second electrode is formed on the capacitor dielectric within a remaining volume of the capacitor cavity. Numerous configurations and variations will be apparent in light of this disclosure.

### General Overview

As previously noted above, it can be challenging to provide effective area scaling for capacitor structures. Passive metal-insulator-metal (MIM) capacitors protect against power delivery noise and can provide a charge reservoir close to the transistors. Their performance is measured in capacitance/area. Typical MIM capacitors stack electrode and high-K dielectric films in a planar fashion, which makes the capacitance directly dependent on the occupied two dimensional area. However, it becomes increasingly challenging to integrate such capacitors in densely packed devices with limited available footprint.

With such little space available to use capacitors, creative measures can be taken to incorporate capacitors by leveraging the existence of other conductive structures that are already a part of the integrated circuit. Thus, techniques are provided herein for forming MIM capacitors either directly alongside or in-line with TSV structures. The TSV structures can be any size, such as relatively large TSVs that extend through a large portion of the substrate (e.g., having a height between 10 and 75 um) or nano-scale TSVs that extend through a device layer with semiconductor devices. The device layer may have a height of less than 1000 nm or less than 500 nm. The MIM capacitors include two electrodes and a capacitor dielectric sandwiched between the two electrodes. In some of the example structures, a first capacitor electrode directly contacts a corresponding TSV structure, which provides electrical contact to the first electrode. A separate contact can be used to provide electrical contact with the second electrode. In some embodiments, the first capacitor electrode runs along a side of the TSV structure while the capacitor dielectric and second capacitor electrode similarly run alongside the TSV structure to form the MIM capacitor along the sidewalls of the TSV structure. In such an arrangement, a backside or buried conductor can contact a bottom of the TSV to provide electrical contact with the first electrode while a top-side contact may be formed to make direct contact with the second electrode from above the MIM capacitor. In some embodiments, the first capacitor is formed within the same via recess as the TSV (e.g., in-line), such that the first capacitor contacts a top surface of a portion of the TSV at the bottom of the via recess. The capacitor dielectric and second capacitor make up the remaining volume of the via recess. In such an arrangement, the TSV makes direct contact to the first electrode from beneath the MIM capacitor and a top-side contact may be formed to make direct contact with the second electrode from above the MIM capacitor. In some embodiments, the first capacitor is formed within a cavity directly adjacent to the TSV such that the first capacitor contacts a sidewall surface of the TSV. The capacitor dielectric and second capacitor make up the remaining volume of the cavity. In such an arrangement, the TSV makes direct contact to the first electrode from an adjacent side of the MIM capacitor and a top-side contact may be formed to make direct contact with the second electrode from above the MIM capacitor.

According to an embodiment, an integrated circuit includes a plurality of semiconductor devices in a first region of a substrate, one or more conductive vias extending through a thickness of the substrate in a second region of the substrate, and a capacitor around a via of the one or more conductive vias. The capacitor includes a first electrode contacting a sidewall of the via, a dielectric layer on the first electrode, and a second electrode on the dielectric layer and extending along a top surface of a portion of the substrate. The integrated circuit also includes a conductive contact arranged to contact the second electrode.

According to another embodiment, an integrated circuit includes a plurality of semiconductor devices in a first region of a device layer, a dielectric layer on a top surface of the device layer, and a capacitor extending through the dielectric layer and the device layer in a second region of the device layer. The capacitor includes a first electrode along an outer edge of the capacitor, a dielectric layer on the first electrode and extending above and over the first electrode, and a second electrode on the dielectric layer and extending above the first electrode. The integrated circuit also includes a conductive plug beneath the first electrode and directly contacting the first electrode.

According to another embodiment, an integrated circuit includes a plurality of semiconductor devices in a first region of a device layer, a dielectric layer on a top surface of the device layer, a via extending through an entire thickness of the dielectric layer and the device layer in a second region of the device layer, and a capacitor extending through the dielectric layer and the device layer and adjacent to the via. The capacitor includes a first electrode along an outer edge of the capacitor and contacting a sidewall of the via, a dielectric layer on the first electrode and extending above and over the first electrode, and a second electrode on the dielectric layer and extending above the first electrode.

The techniques can be used with any type of planar and non-planar transistors, including finFETs (sometimes called double-gate transistors, or tri-gate transistors), nanowire and nanoribbon transistors (sometimes called gate-all-around transistors), and thin film transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a remove metal gate, or RMG, process). Any number of semiconductor materials can be used in forming the transistors to which power is being supplied by a buried or backside power rail, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of relatively large (e.g., at least 10 µm in height) MIM capacitor layers around the outside edge of a TSV structure. In some examples, such tools may indicate the presence of a MIM capacitor structure within a via recess and directly above a portion of a nano-scale via. In some examples, such tools may indicate the presence of a MIM capacitor structure directly adjacent to a nano-scale via, such that the via directly contacts one of the capacitor electrodes.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants

(e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer.

### Architecture

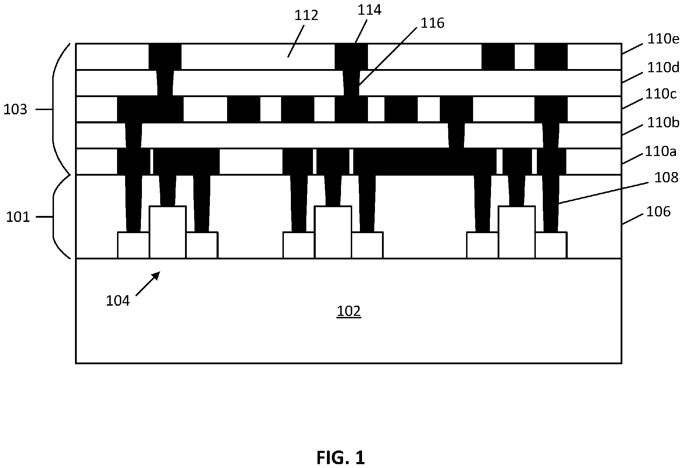

Figure 1 is a cross-sectional view that illustrates an example portion of an integrated circuit having an interconnect region above a plurality of semiconductor devices, in accordance with an embodiment of the present disclosure. The semiconductor devices in this example are non-planar metal oxide semiconductor (MOS) transistors, such as tri-gate or gate-all-around (GAA) transistors, although other transistor topologies and types can also benefit from the techniques provided herein, as will be appreciated (e.g., planar transistors, forksheet transistors, thin film transistors, or any other transistors to which contact can be made).

According to some embodiments, the integrated circuit includes a device region 101 (sometimes referred to as a device layer), and an interconnect region 103 over the device region 101. Device region 101 may include a plurality of semiconductor devices 104 along with one or more other layers or structures associated with the semiconductor devices 104. For example, device region 101 can also include one or more dielectric layers 106 that surround active portions or contacts of the semiconductor devices 104. Device region 101 may also include one or more conductive contacts 108 that provide electrical contact to transistor elements such as gate structures, drain regions, or source regions. Conductive contacts 108 include, for example, tungsten, although other metal or metal alloy materials may be used as well. Conductive contacts may also be a part of, or otherwise include, what is sometimes called a local interconnect, which is considered part of the device layer and usually formed prior to any backend processing.

In some embodiments, device region 101 is formed on or over a substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, backside processing is used to remove substrate 102 and form any number of backside interconnect layers.

Interconnect region 103 includes a plurality of interconnect layers 110a - 110e stacked over one another. Each interconnect layer can include a dielectric material 112 along with one or more different conductive features. Dielectric material 112 can be any dielectric, such as silicon oxide, silicon oxycarbide, silicon nitride, or silicon oxynitride. Dielectric material 112 may be deposited using any known dielectric deposition technique such as chemical vapor deposition (CVD), plasma-enhanced chemical vapor deposition (PECVD), flowable CVD, spin-on dielectric, or atomic layer deposition (ALD). The one or more conductive features can include conductive traces 114 and conductive vias 116 arranged in any pattern across the interconnect layers 110a- 110e to carry signal and/or power voltages to/from the various semiconductor devices 104. A conducive via, such as conductive via 116, may extend through an interconnect layer to connect between conductive traces on an upper interconnect layer and a lower interconnect layer. In other cases, a via 116 may only extend part way through a given interconnect layer. Although interconnect region 103 is illustrated with only five interconnect layers, any number of interconnect layers can be used within interconnect region 103. Also, this example shows vias and lines in different interconnect layers, in both single and dual damascene configurations. In other examples, vias and lines may also exist within the same interconnect layer, such as in the case of some dual damascene configurations.

Any of conductive traces 114 and conductive vias 116 can include any number of conductive materials, with some examples including copper, ruthenium, tungsten, cobalt, molybdenum, and alloys thereof. In some cases, any of conductive traces 114 and conductive vias 116 include a relatively thin liner or barrier, such as titanium nitride, titanium silicide, tungsten carbo-nitride (WCN), PVD or ALD tungsten, or tantalum nitride.

It should be noted that each of the various conductive vias 116 and conductive contacts 108 are shown with tapered profiles to indicate a more natural appearance due to the etching process used to form the openings. Any degree of tapering may be observed depending on the etch parameters used and the thickness of the dielectric layer being etched through. Furthermore, conductive vias may be stacked one over the other through different dielectric layers of interconnect region 103. However, in some examples, a single via recess may be formed through more than one dielectric layer yielding a taller, more tapered conductive via that extends through two or more dielectric layers.

The various interconnect layers of interconnect region 103 may not all be the same thickness. According to some embodiments, the interconnect layers increase in thickness moving upwards towards the top of interconnect region 103. Thus, the top-most interconnect layer may have the greatest thickness while the bottom-most interconnect layer may have the smallest thickness. In some examples, the top-most interconnect layer may have a thickness in the range of several micrometers (e.g., 1 - 4 µm), while the bottom-most interconnect layer may have a thickness of less than 50 nm.

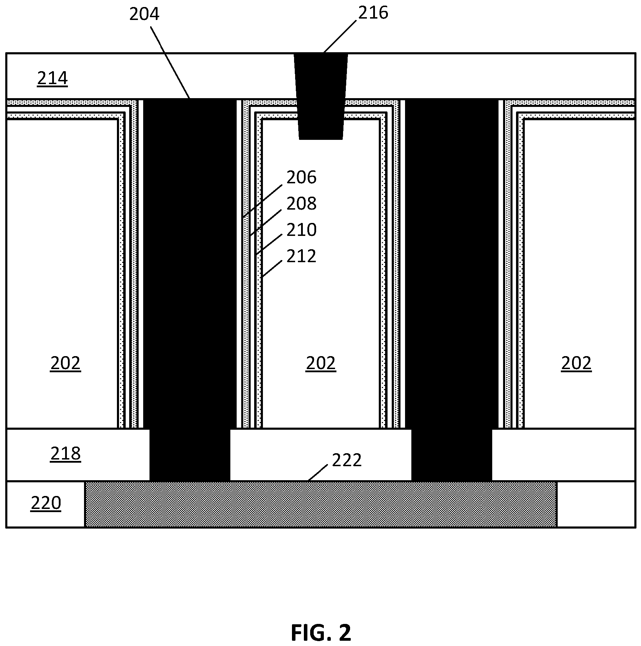

Figure 2 illustrates a cross-section view of a portion of a substrate 202 having vias 204 and capacitor structures formed around vias 204, according to some embodiments. Substrate 202 may have a thickness, for instance, in the micrometer range, such as between 1 µm and 100 µm, although any thickness can be used that will allow for a desired capacitance value (e.g., thicker substrate allows for taller MIM structure which in turn allows for higher capacitance). Substrate 202 may be any, for example, suitable semiconductor material, such as silicon, silicon germanium (SiGe), germanium, or any III-V based materials. In some such cases, substrate 202 may be a device layer and include a number of transistor devices, and vias 204 may be referred to as, for example, through silicon vias (TSVs) or other through-semiconductor vias. In other examples, substrate 202 may be a dielectric material, such as silicon dioxide, ceramic, glass, or polymer, and vias 204 need not be TSVs but instead may be vias that pass through dielectric material.

According to some embodiments, vias 204 include a conductive material that extends through an entire thickness of substrate 202. Vias 204 may include any suitable metal material, such as copper, tungsten, aluminum, cobalt, molybdenum, ruthenium, titanium, or tantalum, to name a few examples. Any number of such vias 204 may be provided at various locations across substrate 202 to route signal and/or power between topside and bottom-side interconnects. The shape of vias 204 generally conforms to the shape of the recess in which the given via is formed, which can be, for instance, circular or square or the like, and the dimensions of vias 204 can vary from one embodiment to the next (e.g., height in the range of 1 µm and 100 µm and a width or diameter in the range of 250 nm to 25 µm).

According to some embodiments, a MIM capacitor is provided around sidewalls of vias 204, such that vias 204 provide electrical connection to one of the plates of the MIM capacitor. The MIM capacitor includes dielectric material sandwiched between two conductive electrodes. According to some embodiments, the MIM capacitor includes a first electrode 206 that contacts a sidewall of a given via 204. First electrode 206 may extend along an entire height of via 204 or along at least a portion of the entire height of via 204. First electrode 206 may extend around an entire outside surface of via 204. First electrode 206 may include any suitable conductive material (e.g., metal, transition metal, conductive ceramic), such as copper, ruthenium, cobalt, hafnium, molybdenum, niobium, tantalum, titanium, tungsten, vanadium, zirconium, or a nitride of these. In some examples, first electrode 206 includes titanium nitride. The thickness of first electrode 206 may vary from one embodiment to the next, but in some examples, first electrode 206 has a thickness between about 10 nm and about 100 nm extending laterally (in the horizontal direction) from the sidewall of via 204.

As further shown in the example of Figure 2, the MIM capacitor includes a capacitor dielectric 208 on first electrode 206. Capacitor dielectric 208 may represent a single layer or multiple layers of dielectric material. According to some embodiments, capacitor dielectric 208 includes at least one high-k dielectric material, such as a material with a dielectric constant equal to or greater than that of silicon nitride. In one example, capacitor dielectric 208 includes a layer of hafnium oxide or aluminum oxide, although other high-k dielectrics may be used. The thickness of capacitor dielectric 208 may vary from one embodiment to the next, but in some examples, capacitor dielectric 208 has a thickness between about 10 nm and about 100 nm.

According to some embodiments, capacitor dielectric 208 runs along first electrode 206 on the outside of via 204 and also runs horizontally (or substantially horizontally) along a top surface of substrate 202. Capacitor dielectric 208 may extend continuously along any number of adjacent vias 204 by wrapping around each of the adjacent vias 204 and extending across a top surface of substrate 202 between each of the vias 204. As further shown in this example, first electrode 206 is not continuous along the upper top surface of substrate 202 and between each of vias 204, so as to allow for contact to be made to a second electrode of the MIM capacitor, without short-circuiting the electrodes, as is further described below.

As further shown in the example of Figure 2, the MIM capacitor includes a second electrode 210 on capacitor dielectric 208. In some examples, second electrode 210 follows capacitor dielectric 208 along the sidewalls of vias 204 and along the top surfaces of substrate 202. Second electrode 210 may include any suitable conductive material, such as those described with respect to first electrode 206. In some examples, second electrode 210 includes titanium nitride. Due to the sandwich layout with capacitor dielectric 208, second electrode 210 is separated from first electrode 206 by capacitor dielectric 208. The thickness of second electrode 210 may vary from one embodiment to the next, but in some examples, second electrode 210 has a thickness between about 10 nm and about 100 nm. Due to the continuous capacitor layers extending along any number of vias 204, the MIM capacitor has a three-dimensional (3D) shape that wraps around the vias 204 and utilizes the vias 204 to provide electrical contact to first electrode 206. The 3D shape of the MIM capacitor increases the surface area between the electrodes within a relatively small footprint. Other variations can be used as well, so as to provide a capacitor structure with a desired amount of capacitance.

According to some embodiments, a liner 212 is provided between second electrode 210 and substrate 202. Liner 212 may be any suitable dielectric material to provide electrical isolation between second electrode 210 and substrate 202. In some examples, liner 212 includes silicon dioxide, although other oxide materials could be used as well. In still other embodiments, dielectrics such as nitrides, carbides, oxycarbides, oxycarbonitrides may be used.

A top dielectric layer 214 is provided over a top surface of vias 204, according to some embodiments. Top dielectric layer 214 may be, for example, an interconnect layer that is part of a local interconnect scheme or a topside interconnect structure that includes any number of interconnect layers. Top dielectric layer 214 may be any suitable dielectric material, such as silicon dioxide, silicon nitride, or silicon oxynitride. The thickness of layer 214 may vary from one example to the next, and in some examples is in the nanometer or micron range (e.g., 200 nm to 100 µm). According to some embodiments, a topside contact 216 is provided to make electrical contact with second electrode 210. Topside contact 216 may extend through a thickness of top dielectric layer 214 and through capacitor dielectric 208 to contact second electrode 210. According to some embodiments, a mask is patterned on layer 214, with an opening in the mask provisioned in the desired location for top contact 216, and a recess is etched through that opening, and topside contact 216 is deposited into that recess, which in this example extends into a portion of substrate 202. Topside contact 216 may include any suitable conductive material, such as those described with respect to electrodes 206 and 210.

Backside connection to vias 204 may be provided, for example, using backside interconnect structures. According to some embodiments, a backside dielectric layer 218 is formed beneath substrate 202 and around a bottom portion of vias 204, such that a bottom surface of vias 204 is substantially coplanar with a bottom surface of backside dielectric layer 218. Backside dielectric layer 218 may be any suitable dielectric material, such as silicon dioxide, silicon nitride, or silicon oxynitride. In some examples, the bottom portions of vias 204 coplanar with backside dielectric layer 218 are conductive contacts that are formed by patterning a mask and etching away portions of layer 218 to expose the bottoms of vias 204 and filling the etched recesses with conductive material to form the contacts. In other examples, bottom portions of the vias 204 are exposed by way of a selective backside etch, followed by a deposition of dielectric material to form layer 218 around those exposed bottom portions. A second backside dielectric layer 220 may be provided beneath backside dielectric layer 218 and may have substantially the same properties as backside dielectric layer 218. As further shown in this example, a backside conductive layer 222 is provided within second backside dielectric layer 220 to contact the bottom surface of vias 204, in a lithographic process (e.g. patterned mask and etch process). Backside conductive layer 222 may include any suitable conductive material, such as those previously described above. The thickness of layers 218 and 220 may vary from one example to the next, and in some examples is in the nanometer or micron range (e.g., 200 nm to 200 µm). Any suitable backside interconnect design can be used to make electrical contact with vias 204. In this particular example, backside conductive layer 222 provides the electrical connection to first electrode 206 of the MIM capacitor and topside contact 216 provides the electrical connection to second electrode 210 of the MIM capacitor.

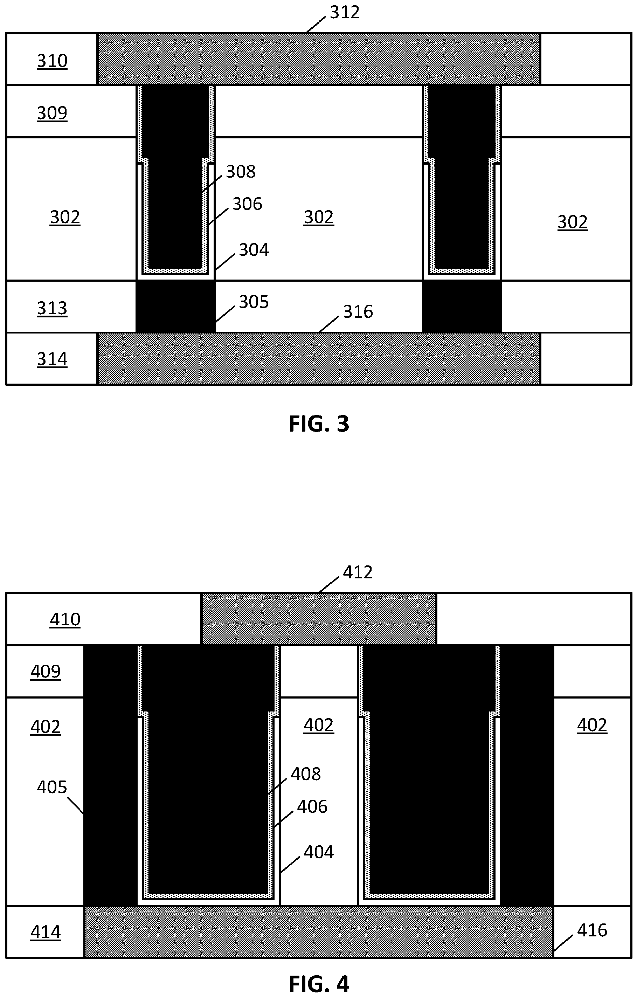

Figure 3 illustrates an example of a MIM capacitor integrated with a nano-scale via, according to some embodiments. In the illustrated example, the MIM capacitor sits on top of a portion of the via. The entire combinational via-plus-capacitor structure extends through a thickness of a device layer 302, which in some examples may include any suitable semiconductor material, such as silicon, SiGe, germanium, or any III-V based materials. In such cases, the via may be referred to as a through-semiconductor via or TSV. In other cases, the portion of the device layer 302 through which the via passes may be a dielectric material (e.g., silicon dioxide). In this example, the device layer 302 may have a total thickness of less than 1000 nm or less than 500 nm, such as between 50 nm and 300 nm. Other regions of device layer 302 may include any number of semiconductor devices, such as planer transistors, thin film transistors (TFTs), trigate transistors, gate-all-around transistors, or forksheet transistors.

In this example, the MIM capacitor includes a first electrode 304 directly on a top surface of a conductive plug 305. First electrode 304 also extends at least partially up sidewalls of device layer 302. Conductive plug 305 may be a portion of a nano-scale via that has been recessed to leave behind only conductive plug 305 at the bottom. Accordingly, conductive plug 305 may include any suitable conductive material, such as those previously described (e.g., copper, tungsten, titanium nitride, tantalum nitride, ruthenium, molybdenum, or cobalt). The shape of conductive plug 305 generally conforms to the shape of the recess in which it is formed, which can be, for instance, circular or square or the like, and the dimensions of conductive plug 305 can vary from one embodiment to the next. According to some embodiments, conductive plug 305 may have a height between about 10 nm and about 100 nm, and a total width or diameter between about 25 nm and about 100 nm. Other examples may have different plug dimensions.

First electrode 304 may be any suitable conductive material, such as those previously described (e.g., tungsten, titanium nitride, tantalum nitride, ruthenium, cobalt, molybdenum, or copper). In some examples, first electrode 304 includes titanium nitride. The thickness of first electrode 304 may vary from one example to the next, and in some examples, first electrode 304 has a thickness between about 5 nm and about 10 nm. Other examples may have thinner or thicker first electrodes 304, giving consideration to factors such as desired resistance of electrode, surface area of electrode, and potential (voltage) of a given application.

As further shown in this example, the MIM capacitor includes a capacitor dielectric 306 on first electrode 304. Capacitor dielectric 306 may represent a single or multiple layers of dielectric material. According to some embodiments, capacitor dielectric 306 includes at least one high-k dielectric material, such as a material with a dielectric constant equal to or greater than that of silicon nitride. In one example, capacitor dielectric 306 includes a layer of hafnium oxide or aluminum oxide, although other high-k dielectrics may be used. The thickness of capacitor dielectric 306 may vary from one example to the next, and in some examples, capacitor dielectric 306 has a thickness between about 5 nm and about 10 nm. Other examples may have thinner or thicker capacitor dielectric 306, giving consideration to factors such as desired breakdown voltage rating and potential (voltage) of a given application. According to some embodiments, capacitor dielectric 306 extends along an entire inner surface of first electrode 304 and also extends over a top end of first electrode 304. Thus, capacitor dielectric 306 may "pinch off' first electrode 304 as dielectric 306 extends up and along the sidewall of device layer 302. Capacitor dielectric 306 may continue extending up sidewalls of device layer 302 above first electrode 304 and may also extend along sidewalls of first top dielectric layer 309, as shown in the example of Figure 3,.

As further shown, a second electrode 308 of the MIM capacitor is provided on capacitor dielectric 306. Second electrode 308 may be a conductive material that substantially fills a volume between capacitor dielectric 306 as it extends up the sidewalls of first electrode 304 and device layer 302. Second electrode 308 may be any suitable conductive material, such as those previously described (e.g., tungsten, titanium nitride, tantalum nitride, ruthenium, cobalt, molybdenum, or copper). Similar to that described with respect to conductive plug 305, the shape of second electrode 308 generally conforms to the shape of the recess in which the MIM structure is formed, which can be, for instance, circular or square or the like, and the dimensions of second electrode 308 can vary from one embodiment to the next (e.g., height in the range of 30 nm to 100 nm and a width in the range of 20 nm to 50 nm). In some examples, second electrode 308 includes titanium nitride. Capacitor dielectric 306 separates second electrode 308 from first electrode 304 to provide the MIM structure. Capacitor dielectric 306 and first electrode 304 may be conformal in nature based on their respective deposition processes, which in turn may preserve the shape of the recess in which second electrode 308 is deposited.

According to some embodiments, a portion of the MIM capacitor also extends through a first top dielectric layer 309. First top dielectric layer 309 may contact a top surface of device layer 302. First top dielectric layer 309 may be any suitable dielectric material, such as silicon dioxide, silicon nitride, or silicon oxynitride. A second top dielectric layer 310 is provided over a top surface of first top dielectric layer 309, according to some embodiments. Second top dielectric layer 310 may be, for example, local interconnect layer or part of a topside interconnect structure including many interconnect layers. Second top dielectric layer 310 may be any suitable dielectric material, such as silicon dioxide, silicon nitride, or silicon oxynitride. According to some embodiments, a topside conductive layer 312 is provided through second top dielectric layer 310 to make electrical contact with second electrode 308. In the illustrated example, topside conductive layer 312 extends to contact more than one second electrode 308 of more than one MIM capacitor. Topside conductive layer 312 may provide electrical contact to the second electrodes of any number of MIM capacitors in this way. In other examples, topside conductive layer 312 contacts the second electrode 308 of only one MIM capacitor structure. Topside conductive layer 312 may include any suitable conductive material, such as previously described (e.g., copper, tungsten, titanium nitride, tantalum nitride, ruthenium, molybdenum, or cobalt).

According to some embodiments, a first bottom dielectric layer 313 extends around conductive plugs 305 and is on a bottom surface of device layer 302. First bottom dielectric layer 313 may be any suitable dielectric material, such as silicon dioxide, silicon nitride, or silicon oxynitride. A second bottom dielectric layer 314 is provided under a bottom surface of first bottom dielectric layer 313, according to some embodiments. Second bottom dielectric layer 314 may be part of a backside interconnect structure. Second bottom dielectric layer 314 may be any suitable dielectric material, such as silicon dioxide, silicon nitride, or silicon oxynitride. According to some embodiments, a backside conductive layer 316 is provided through second bottom dielectric layer 314 to make electrical contact with one or more conductive plugs 305. In the illustrated example, backside conductive layer 316 extends to contact more than one conductive plug 305. Each conductive plug 305 directly contacts first electrode 304, such that backside conductive layer 316 provides electrical connection to first electrode 304. Backside conductive layer 316 may provide electrical connection to the first electrodes of any number of MIM capacitors in this way. In other examples, backside conductive layer 316 contacts the conductive plug 305 beneath only one MIM capacitor structure. Backside conductive layer 316 may include any suitable conductive material, such as those previously described (e.g., copper, tungsten, ruthenium, molybdenum, or cobalt).

Figure 4 illustrates another example of a MIM capacitor integrated with a nano-scale TSV, according to some embodiments. In the illustrated example, the MIM capacitor sits directly adjacent to a TSV. The entire MIM capacitor extends through a thickness of a device layer 402, which may be substantially similar to device layer 302 described above.

In this example case, the MIM capacitor includes a first electrode 404 that extends along a bottom surface of the MIM capacitor and partially along sidewalls of the MIM capacitor. According to some embodiments, at least a portion of first electrode 404 extends along a sidewall of an adjacent TSV 405. TSV 405 may include any suitable conductive material, such as copper, tungsten, ruthenium, molybdenum, or cobalt. According to some embodiments, TSV 405 extends along the entire height of the MIM capacitor. In some examples, TSV 405 has a height between about 200 nm and about 500 nm, and a total width between about 25 nm and about 100 nm.

First electrode 404 may be any suitable conductive material, such as those previously described (e.g., tungsten, ruthenium, cobalt, molybdenum, or copper). In some examples, first electrode 404 includes titanium nitride. In some examples, first electrode 404 has a thickness between about 5 nm and about 10 nm, although other examples may have a different thickness range.

As further shown in this example, the MIM capacitor includes a capacitor dielectric 406 on first electrode 404. Capacitor dielectric 406 may represent a single or multiple layers of dielectric material. According to some embodiments, capacitor dielectric 406 includes at least one high-k dielectric material, such as a material with a dielectric constant equal to or greater than that of silicon nitride. In one example, capacitor dielectric 406 includes a layer of hafnium oxide or aluminum oxide, although other high-k dielectrics may be used. In some examples, capacitor dielectric 406 has a thickness between about 5 nm and about 10 nm, although other examples may have a different thickness range. According to some embodiments, capacitor dielectric 406 extends along an entire inner surface of first electrode 404 and also extends over a top end of first electrode 404. Thus, capacitor dielectric 406 may "pinch off' first electrode 404 as it extends up and along the sidewall of device layer 402. Capacitor dielectric 406 may continue extending up sidewalls of device layer 402 above first electrode 404 and may also extend along sidewalls of first top dielectric layer 409.

As further shown in this example, a second electrode 408 of the MIM capacitor is provided on capacitor dielectric 406. Second electrode 408 may be a conductive material that substantially fills a volume between capacitor dielectric 406 as it extends up the sidewalls of first electrode 404 and device layer 402. Second electrode 408 may be any suitable conductive material, such as those previously described (e.g., tungsten, titanium nitride, ruthenium, cobalt, molybdenum, or copper). Capacitor dielectric 406 separates second electrode 408 from first electrode 404 to provide the MIM structure.

According to some embodiments, a portion of the MIM capacitor and TSV 405 also extends through a first top dielectric layer 409. First top dielectric layer 409 may contact a top surface of device layer 402. First top dielectric layer 409 may be any suitable dielectric material, such as silicon dioxide, silicon nitride, or silicon oxynitride. A second top dielectric layer 410 is provided over a top surface of first top dielectric layer 409, according to some embodiments. Second top dielectric layer 410 may be, for example, a local interconnect layer, or part of a topside interconnect structure. Second top dielectric layer 410 may be any suitable dielectric material, such as silicon dioxide, silicon nitride, or silicon oxynitride. According to some embodiments, a topside conductive layer 412 is provided through second top dielectric layer 410 to make electrical contact with second electrode 408. In the illustrated example, topside conductive layer 412 extends to contact more than one second electrode 408 of more than one MIM capacitor. Topside conductive layer 412 may provide electrical contact to the second electrodes of any number of MIM capacitors in this way. In other examples, topside conductive layer 412 contacts the second electrode 408 of only one MIM capacitor structure. Topside conductive layer 412 may include any suitable conductive material, such as those previously described (e.g., aluminum, copper, tungsten, ruthenium, molybdenum, or cobalt).

According to some embodiments, a bottom dielectric layer 414 is provided under a bottom surface of device layer 402, according to some embodiments. Bottom dielectric layer 414 may be part of a backside interconnect structure. Bottom dielectric layer 414 may be any suitable dielectric material, such as silicon dioxide, silicon nitride, or silicon oxynitride. According to some embodiments, a backside conductive layer 416 is provided through bottom dielectric layer 414 to make electrical contact with first electrode 404 and/or TSV 405. In the illustrated example, backside conductive layer 416 extends to contact the first electrode 404 of more than one MIM capacitor. Backside conductive layer 416 may provide electrical contact to the first electrodes of any number of MIM capacitors in this way. In other examples, backside conductive layer 416 contacts the first electrode 404 beneath only one MIM capacitor structure. Backside conductive layer 416 may include any suitable conductive material, such as those previously described (e.g., copper, tungsten, ruthenium, molybdenum, or cobalt).

### Fabrication Methodology

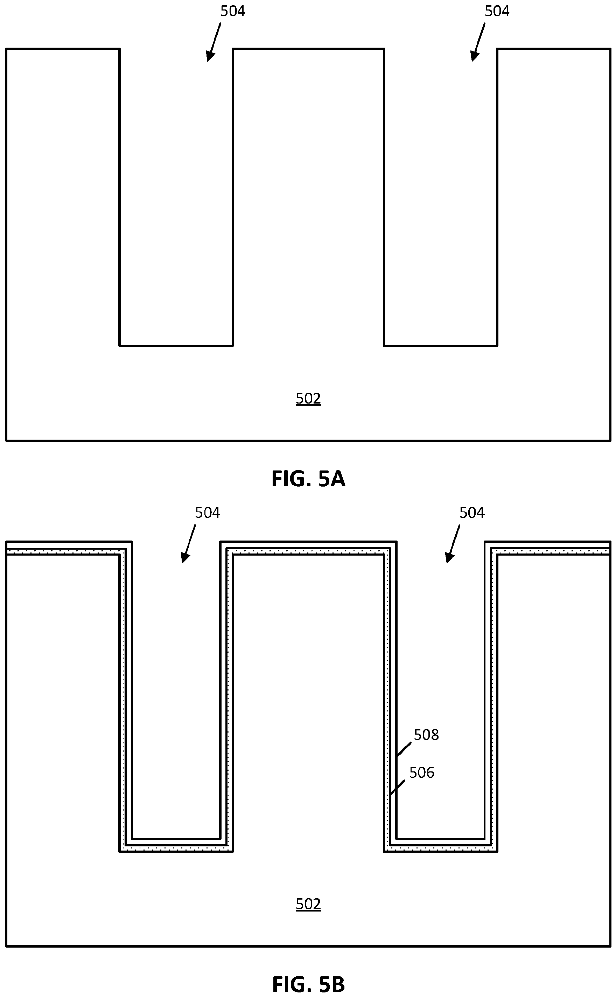

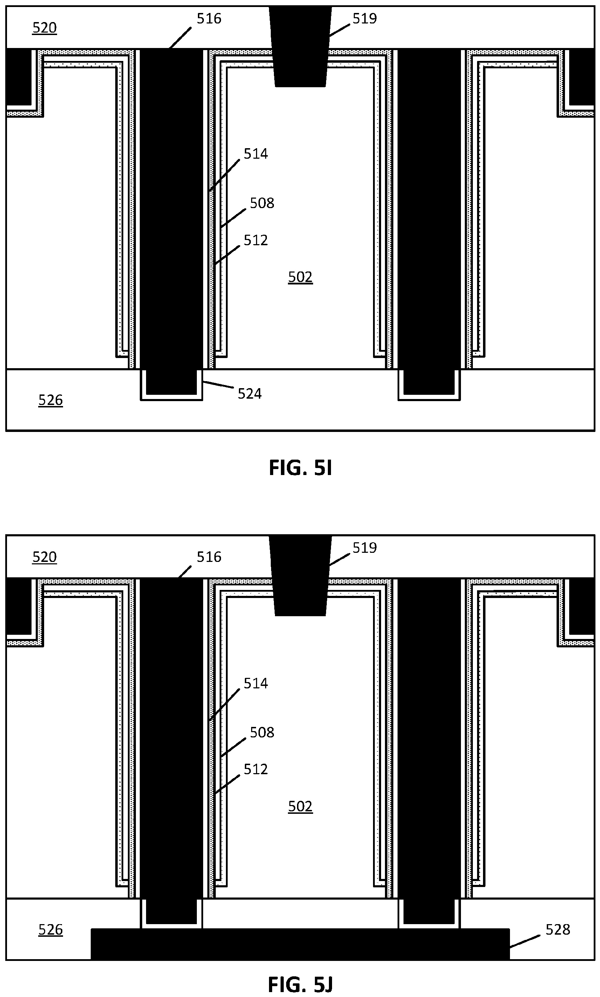

Figures 5A - 5J are cross-sectional views that collectively illustrate an example process for forming a portion of an integrated circuit, in accordance with an embodiment of the present disclosure. Each figure shows an example structure that results from the process flow up to that point in time, so the depicted structure evolves as the process flow continues, culminating in the MIM capacitor structure shown in Figure 5J, which is similar to the structure illustrated in Figure 2. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 5A is a cross sectional view taken through a portion of a substrate 502. Substrate 502 may be substantially similar to substrate 102 discussed above with reference to Figure 1. Accordingly, substrate 502 may include any suitable semiconductor material, although other substrate materials (e.g., dielectric substrates) can be used as well. According to some embodiments, deep recesses 504 are etched through a portion of substrate 502. A reactive ion etch (RIE) process may be used along with suitable lithography techniques to pattern and etch recesses 504. According to some embodiments, recesses 504 may be trenches that extend into and out of the page. Recesses 504 may have a depth of, for example, between about 10 µm and about 75 µm. Other examples may be configured differently. Any number of recesses 504 may be provided depending on the number of desired TSVs.

Figure 5B is a cross sectional view of the structure depicted in Figure 5A, after formation of a liner 506 and a first electrode 508, according to some embodiments. Liner 506 may be any suitable dielectric material, such as silicon dioxide or silicon nitride. Liner 506 may be conformally deposited (e.g., CVD, ALD) and have any suitable thickness that maintains continuity along the surfaces of recesses 504. In some examples, liner 506 has a thickness between about 20 nm and about 100 nm.

First electrode 508 may include, for example, copper or tungsten or any other conductor that is deposited using any one of electroplating, electroless plating, CVD, ALD, or PECVD, to name a few examples. According to some embodiments, first electrode 508 includes titanium nitride, and is deposited conformally via CVD or ALD. First electrode 508 may be deposited directly on all surfaces within recesses 504 as well as on the top surface of substrate 502 (or on a top surface of any dielectric layers present on the top surface of substrate 502). In some examples, first electrode 508 has a thickness between about 20 nm and about 100 nm.

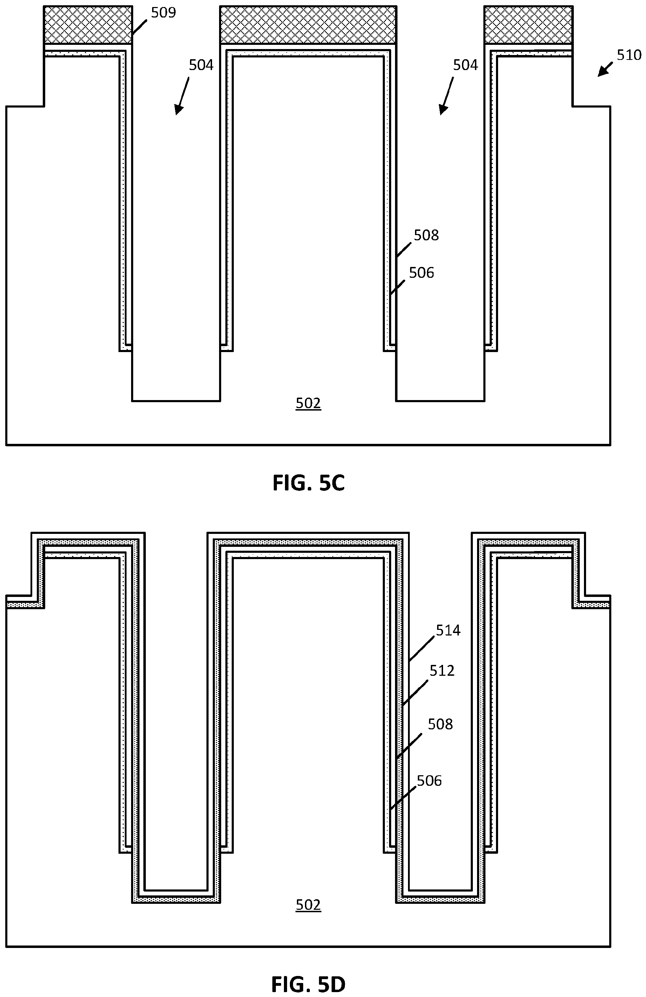

Figure 5C is a cross sectional view of the structure depicted in Figure 5B, after formation of a mask structure 509 and subsequent etching to punch through a bottom of recesses 504, according to some embodiments. Mask structure 509 may be any suitable dielectric material or lithographic masking material, such as photoresist or carbon hard mask (CHM). According to some embodiments, mask structure 509 is patterned to remove any portions of mask structure within recesses 504 and may also be patterned to remove portions outside of recesses 504. An RIE process may be used to etch through any exposed materials not protected by mask structure 509. Accordingly, the etch may punch through both liner 506 and first electrode 508 at the bottom of recesses 504 to extend the depth of recesses 504 further into substrate 502. In some embodiments, smaller recesses 510 may be formed through a top surface of substrate 502 outside of recesses 504 to cut off the extension of first electrode 508 along the top surface of substrate 502.

Figure 5D is a cross sectional view of the structure depicted in Figure 5C, after formation of a capacitor dielectric 512 and a second electrode 514 on capacitor dielectric 512. Capacitor dielectric 512 may represent any number of deposited dielectric layers. In some examples, capacitor dielectric 512 includes a layer of hafnium oxide or any other suitable high-k dielectric material. Capacitor dielectric 512 may be conformally deposited using any suitable dielectric deposition technique, such as CVD, PECVD, ALD, or spin-on dielectric, and may have a thickness between about 20 nm and about 100 nm.

According to some embodiments, capacitor dielectric 512 follows first electrode 508 over the surfaces within recesses 504 and over the top surface of substrate 502. Capacitor dielectric 512 extends deeper than first electrode 508 within recesses 504 such that capacitor dielectric 512 forms along surfaces of substrate 502 at the bottom of recesses 504, according to some embodiments. In some examples, capacitor dielectric 512 also extends over the ends of first electrode 508 outside of recesses 504, such that first electrode 508 is encapsulated by both capacitor dielectric 512 and liner 506.

Second electrode 514 may include copper or tungsten that is deposited using any one of electroplating, electroless plating, CVD, ALD, or PECVD, to name a few examples. Any other suitable conductive materials may be used as well (e.g., aluminum, ruthenium, cobalt, molybdenum). In some examples, first electrode 508 and second electrode 514 are conformally deposited (e.g., ALD or CVD) and include the same conductive material (e.g., titanium nitride). According to some embodiments, second electrode 514 follows capacitor dielectric 512 over all surfaces within recesses 504 and over the top surface of substrate 502.

Due to the sandwich layout with capacitor dielectric 512, second electrode 514 is separated from first electrode 508 by capacitor dielectric 512 along all surfaces within recesses 504 and on the top surface of substrate 502. According to some embodiments, second electrode 514 is deposited to a thickness between about 20 nm and about 100 nm.

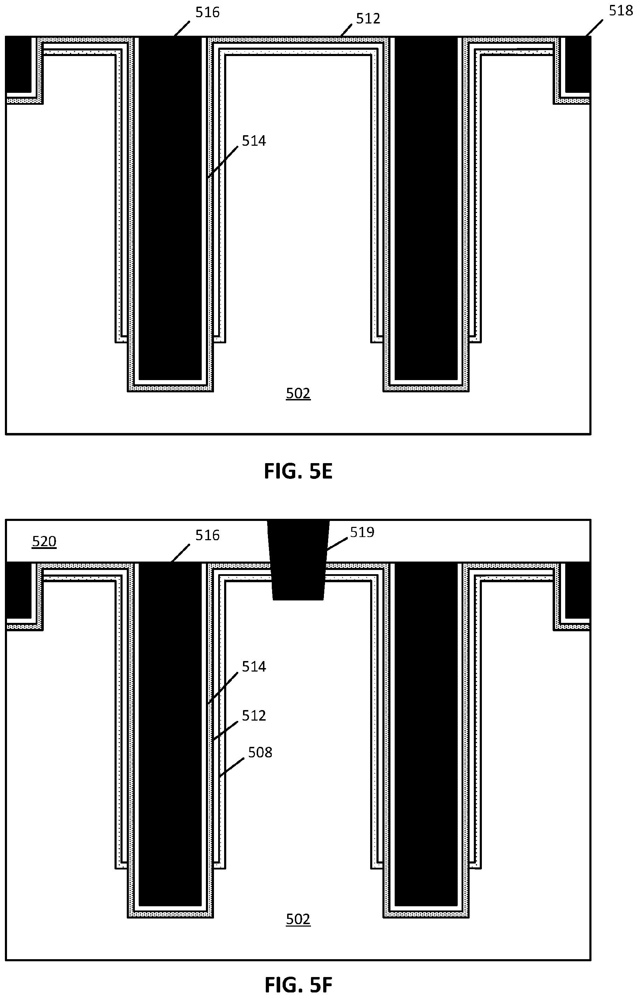

Figure 5E is a cross sectional view of the structure depicted in Figure 5D, after formation of TSVs 516 within a remaining volume of recesses 504, according to some embodiments. TSVs 516 may include any number of suitable conductive materials. TSVs may include a conductive liner and a conductive fill on the conductive liner. The conductive liner may include metals such as tantalum or titanium, and the conductive fill may include metals such as copper, tungsten, cobalt, ruthenium, or molybdenum. Note that some dummy conductive plugs 518 may be formed within the shallow recesses away from TSVs 516. These dummy conductive plugs 518 may not be coupled to any other circuit interconnects.

According to some embodiments, TSVs 516 are formed directly on second electrode 514 within recesses 504. Accordingly, TSVs 516 provide direct electrical connection to second electrode 514 of the MIM capacitor. Following the deposition of the conductive material to form TSVs 516, a polishing procedure is performed using any suitable technique, such as chemical mechanical polishing (CMP). The polishing removes any excess conductive material outside of recesses 504 and is also used to remove portions of second electrode 514 from above the top surface of substrate 502. In this way, second electrode 514 remains around TSVs 516 but does not extend between TSVs 516, according to some embodiments.

Figure 5F is a cross sectional view of the structure depicted in Figure 5E, after formation of a topside contact 519, according to some embodiments. Topside contact 519 may extend through a topside dielectric layer 520 formed over substrate 502. In some examples, topside dielectric layer 520 is formed directly on a top surface of TSVs 516 and on a top surface of capacitor dielectric 512. Topside dielectric layer 520 may be any suitable dielectric material, such as silicon dioxide, silicon nitride, or silicon oxynitride. Topside contact 519 may be formed by first forming a recess that extends through an entire thickness of topside dielectric layer 520 and also extends through the MIM capacitor layers to expose at least first electrode 508. The recess may then be filled with one or more conductive materials to form topside contact 519. Topside contact 519 may include a conductive liner and a conductive fill on the conductive liner. The conductive liner may include metals such as tantalum or titanium, and the conductive fill may include metals such as copper, tungsten, cobalt, ruthenium, or molybdenum.

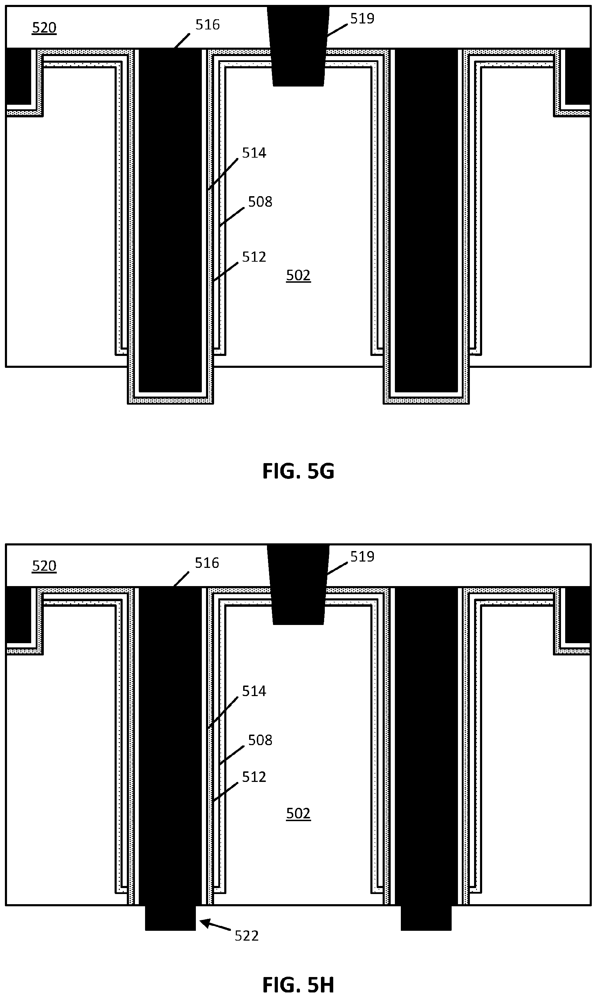

Figure 5G is a cross sectional view of the structure depicted in Figure 5F, after removing a portion of substrate 502 from the backside, according to some embodiments. The backside of substrate 502 may be removed using any number of or combination of techniques such as dry etching, wet etching, polishing, or grinding. In some examples, the backside of substrate 502 is polished or grinded down until the lower surface of capacitor dielectric 512 is exposed. Further recessing of substrate 502 may then be performed using any suitable etching process selective to the TSVs 516 such that a lower portion of TSV 516 protrudes out from the lower surface of substrate 502. Both capacitor dielectric 512 and second electrode 514 may remain around the protruding end of TSV 516. According to some embodiments, the recessing of substrate 502 stops before any portion of liner 506 and/or first electrode 508 is exposed. Thus, a bottom surface of substrate 502 is below any portion of liner 506 and/or first electrode 508, according to some embodiments.

Figure 5H is a cross sectional view of the structure depicted in Figure 5G, after removal of the MIM layers around the protruding end 522 of TSV 516, according to some embodiments. Any suitable isotropic etching processes may be used to remove capacitor dielectric 512 and second electrode 514. According to some embodiments, the etching processes may also cause slight etching to protruding end 522, thus decreasing its width from the remainder of TSV 516.

Figure 5I is a cross sectional view of the structure depicted in Figure 5H, after the formation of a conductive liner 524 around protruding end 522, and a bottom dielectric layer 526, according to some embodiments. Conductive liner 524 may act as a barrier layer to protect any metal ions from TSV 516 from leeching into dielectric layer 526. Conductive liner 524 may include any suitable conductive material, such as tantalum or titanium. Dielectric layer 526 may be formed on the backside of substrate 502 and around protruding ends 522 of TSVs 516. Dielectric layer 526 may be formed directly on the bottom surface of substrate 502 and may be any suitable dielectric material, such as silicon dioxide, silicon nitride, or silicon oxynitride.

Figure 5J is a cross sectional view of the structure depicted in Figure 5I, after the formation of a backside conductive layer 528 beneath TSVs 516, according to some embodiments. Backside conductive layer 528 may be formed through a portion of backside dielectric layer 526, or it may be formed on a lower surface of backside dielectric layer 526. Backside conductive layer 528 may include any suitable conductive material, such as copper, tungsten, ruthenium, molybdenum, or cobalt. Any suitable backside interconnect design can be used to make electrical contact with TSVs 516. According to some embodiments, backside conductive layer 528 provides the electrical connection to second electrode 514 of the MIM capacitor and topside contact 519 provides the electrical connection to first electrode 508 of the MIM capacitor. The entire area of the MIM capacitor wraps around both of the adjacent TSVs 516, according to some embodiments. Any number of adjacent TSVs could be used in this way to extend the total area of the MIM capacitor by omitting the shallow recesses that break up the extension of first electrode 508.

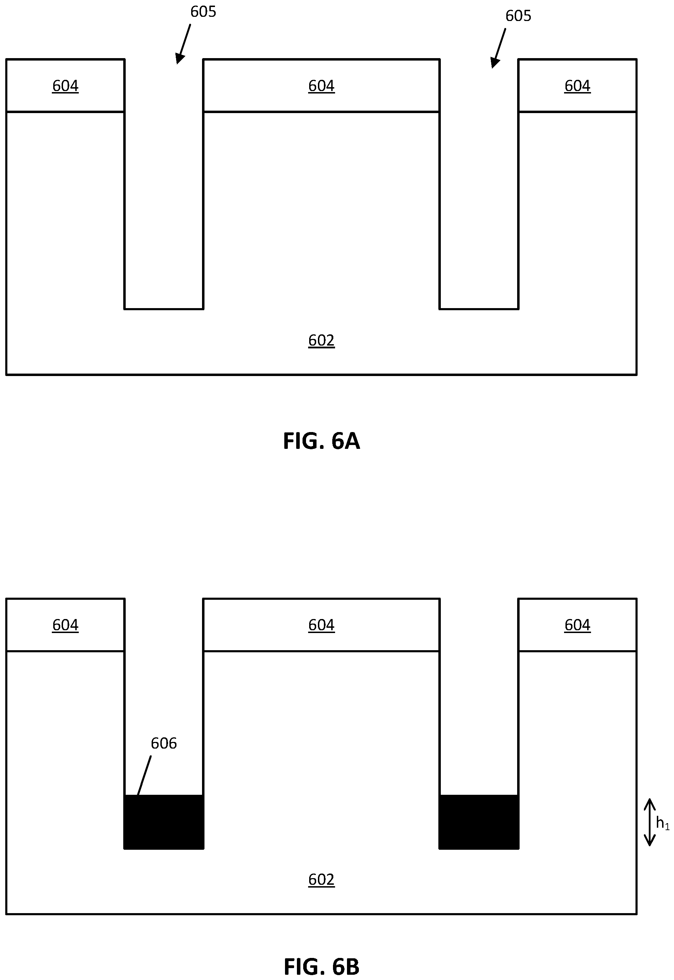

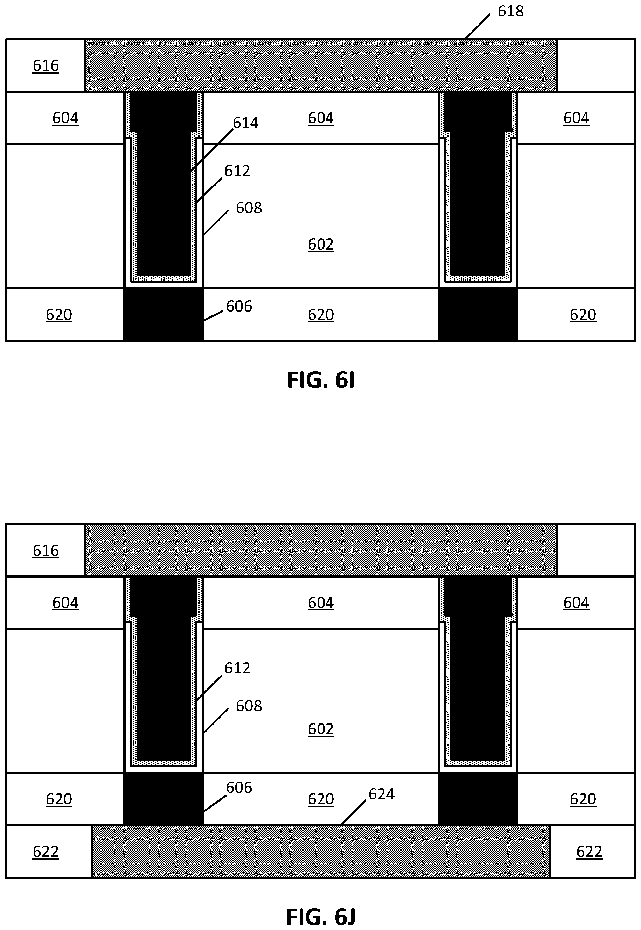

Figures 6A - 6J are cross-sectional views that collectively illustrate an example process for forming a portion of an integrated circuit, in accordance with an embodiment of the present disclosure. Each figure shows an example structure that results from the process flow up to that point in time, so the depicted structure evolves as the process flow continues, culminating in the MIM capacitor structure shown in Figure 6J, which is similar to the structure illustrated in Figure 3. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 6A is a cross sectional view taken through a portion of a device layer 602. Device layer 602 may be substantially similar to device region 101 discussed above with reference to Figure 1. Accordingly, the illustrated portion of device layer 602 may be away from the semiconductor devices and may include any suitable semiconductor material. According to some embodiments, a dielectric layer 604 is provided on a top surface of device layer 602. Dielectric layer 604 may include any suitable dielectric material, such as silicon dioxide, silicon nitride, or silicon oxynitride.

According to some embodiments, recesses 605 are etched through an entire thickness of dielectric layer 604 and through at least a portion of device layer 602. An RIE process may be used along with suitable lithography techniques to pattern and etch recesses 605. According to some embodiments, recesses 605 may be trenches that extend into and out of the page. Recesses 605 may have a depth of between about 100 nm and about 200 nm. Any number of recesses 605 may be provided depending on the number of desired MIM capacitors.

Figure 6B is a cross sectional view of the structure depicted in Figure 6A, after the formation of conductive plugs 606 at the bottom of recesses 605, according to some embodiments. A conductive material may be formed within recesses 605 and may fill an entire volume of recesses 605 before being recessed using any suitable isotropic etching process to a final height h₁. Conductive plugs 606 may include any suitable conductive material, such as tungsten, ruthenium, molybdenum, or cobalt and may have a height h₁ between about 10 nm and about 100 nm. In some examples, a dielectric liner is first formed within recesses 605 to separate conductive plugs 606 and any subsequent MIM capacitor layers from device layer 602. The dielectric liner may include, for instance, silicon dioxide or silicon nitride, to name a few examples.

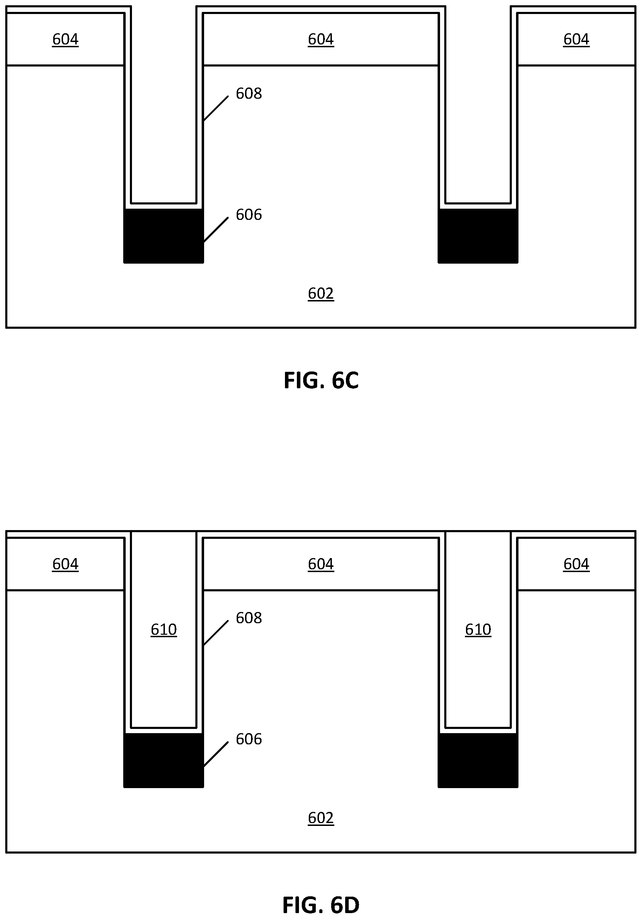

Figure 6C is a cross sectional view of the structure depicted in Figure 6B, after the formation of a first electrode 608, according to some embodiments. First electrode 608 may include tungsten that is deposited using any one of electroplating, electroless plating, CVD, ALD, or PECVD, to name a few examples. Any other suitable conductive materials may be used as well (e.g., aluminum, ruthenium, cobalt, molybdenum). According to some embodiments, first electrode 608 includes titanium nitride. First electrode 608 may be conformally deposited (e.g., ALD, CVD) directly on all surfaces within recesses 605 as well as on the top surface of dielectric layer 604. First electrode 608 is deposited directly on a top surface of conductive plug 606 at the bottom of recess 605, according to some embodiments. In some examples, first electrode 608 has a thickness between about 5 nm and about 20 nm.

Figure 6D is a cross sectional view of the structure depicted in Figure 6C, after the formation of a filler material 610 within a remaining volume of recesses 605, according to some embodiments. Filler material 610 may be any flowable dielectric material or CHM, to name a few examples. According to some embodiments, filler material 610 fills recesses 605 and is polished back to remove any excess filler material 610 from outside of recesses 605. Thus, a top surface of filler material 610 may be polished until it is substantially coplanar with a top surface of first electrode 608 over dielectric layer 604.

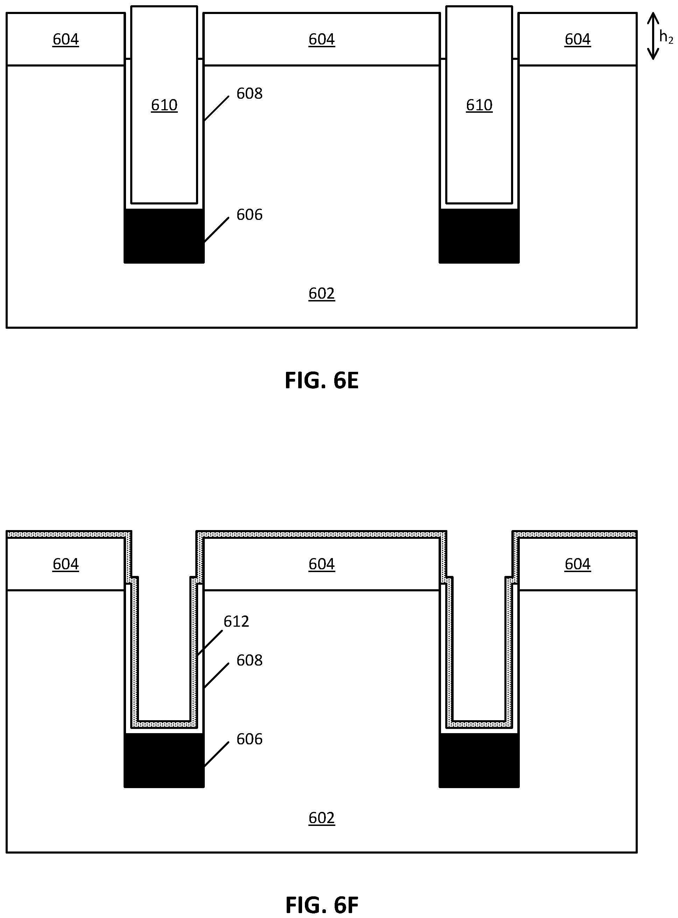

Figure 6E is a cross sectional view of the structure depicted in Figure 6D, after an etching process is performed to recess first electrode 608 by a height h2 below a top surface of dielectric layer 604, according to some embodiments. Any suitable selective isotropic and/or directional etching process may be used to remove exposed portions of first electrode 608, which includes removing a top portion of first electrode 608 along the sidewall surface of filler material 610. According to some embodiments, first electrode 608 may be recessed by a height h₂ between about 10 nm and about 50 nm. Other examples may be configured differently.

Figure 6F is a cross sectional view of the structure depicted in Figure 6E, after the removal of filler material 610 and the subsequent formation of capacitor dielectric 612, according to some embodiments. Capacitor dielectric 612 may represent any number of deposited dielectric layers. In some examples, capacitor dielectric 612 includes a layer of hafnium oxide or any other suitable high-k dielectric material. Like conformal conductor layers for electrodes, the capacitor dielectric 612 may be deposited using any suitable dielectric deposition technique, such as CVD, PECVD, ALD, or spin-on dielectric, and may have a thickness between about 5 nm and about 20 nm.

According to some embodiments, capacitor dielectric 612 follows first electrode 608 over the surfaces within recesses 605 and over the recessed end of first electrode 608. Accordingly, capacitor dielectric 612 may "pinch off' first electrode 608 as it extends along the sidewalls of recess 605. According to some embodiments, capacitor dielectric 612 continues to extend along the sidewalls of recess 605 above first electrode 608 and over the top surface of dielectric layer 604. Capacitor dielectric 612 may extend between any number of adjacent recesses 605 in this way.

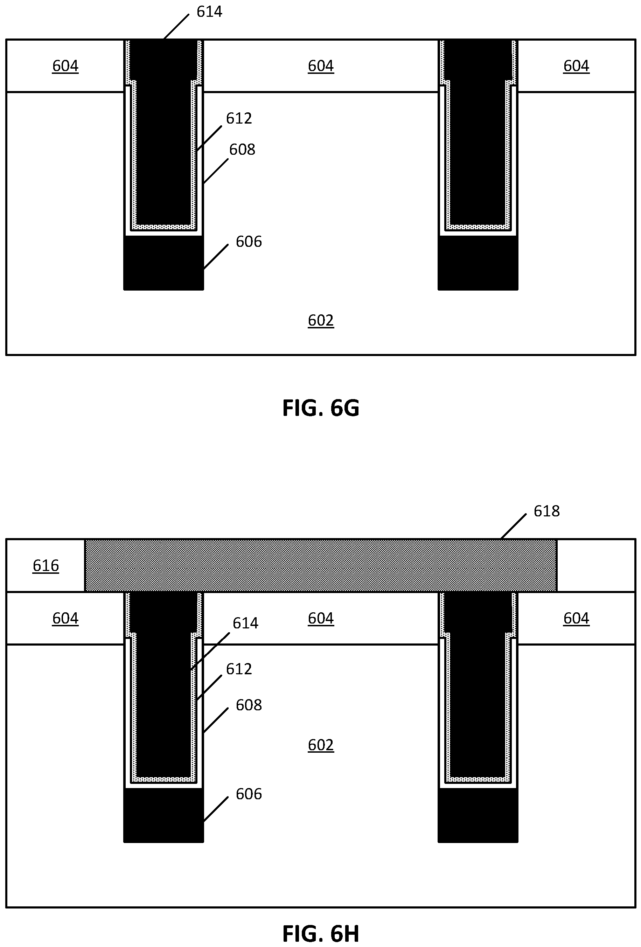

Figure 6G is a cross sectional view of the structure depicted in Figure 6F, after the formation of a second electrode 614, according to some embodiments. Second electrode 614 may include any number of conductive materials, such as a conductive liner and a conductive fill on the conductive liner. In other examples, second electrode 614 has only a conductive fill (with no liner). Any suitable conductive materials may be used for either or both the conductive fill and conductive liner, such as tungsten, ruthenium, molybdenum, or cobalt. In some embodiments, second electrode 614 includes titanium nitride. Second electrode 614 may substantially fill the remaining volume of recess 605 between capacitor dielectric 612. According to some embodiments, second electrode 614 is separated from first electrode 608 by capacitor dielectric 612 along all of first electrode 608. A top surface of second electrode 614 may be polished until it is substantially coplanar with a top surface of dielectric layer 604.

Figure 6H is a cross sectional view of the structure depicted in Figure 6G, after the formation of a topside dielectric layer 616 over dielectric layer 604, and a topside conductive layer 618, according to some embodiments. Topside dielectric layer 616 may be any suitable dielectric material, such as silicon dioxide, silicon nitride, or silicon oxynitride. In some examples, topside dielectric layer 616 includes the same dielectric material as dielectric layer 604.

According to some embodiments, topside conductive layer 618 is provided through topside dielectric layer 616 to make electrical contact with second electrode 614. In the illustrated example, topside conductive layer 618 extends to contact more than one second electrode 614 of more than one MIM capacitor. Topside conductive layer 618 may provide electrical contact to the second electrodes of any number of MIM capacitors in this way. In other examples, topside conductive layer 618 contacts the second electrode 614 of only one MIM capacitor structure. Topside conductive layer 618 may include any suitable conductive material, such as copper, tungsten, ruthenium, molybdenum, or cobalt.

Figure 6I is a cross sectional view of the structure depicted in Figure 6H, after the removal of a backside portion of the substrate and subsequent formation of a first backside dielectric layer 620, according to some embodiments. The backside of the substrate may be removed using any number of or combination of techniques such as dry etching, wet etching, polishing, or grinding. In some examples, the backside of the substrate is polished or grinded down until the lower surface of conductive plugs 606 is exposed. Further recessing of the substrate (which may recess into device layer 602) may then be performed using any suitable etching process such that conductive plugs 606 protrude out from the lower surface of device layer 602. According to some embodiments, the recessing of the substrate or of device layer 602 exposes at least the entire height of conductive plugs 606.

According to some embodiments, first backside dielectric layer 620 may be formed on the bottom surface of device layer 602 and around conductive plugs 606. First backside dielectric layer 620 may be any suitable dielectric material, such as silicon dioxide, silicon nitride, or silicon oxynitride. According to some embodiments, a bottom surface of first backside dielectric layer 602 may be polished until it is substantially coplanar with a bottom surface of conductive plugs 606.

Figure 6J is a cross sectional view of the structure depicted in Figure 6I, after the formation of a second backside dielectric layer 622 and a backside conductive layer 624, according to some embodiments. Second backside dielectric layer 622 may be part of a backside interconnect structure. Second backside dielectric layer 622 may be any suitable dielectric material, such as silicon dioxide, silicon nitride, or silicon oxynitride. According to some embodiments, backside conductive layer 624 is provided through second backside dielectric layer 622 to make electrical contact with one or more conductive plugs 606. In the illustrated example, backside conductive layer 624 extends to contact more than one conductive plug 606. Each conductive plug 606 directly contacts first electrode 608, such that backside conductive layer 624 provides electrical connection to first electrode 608. Backside conductive layer 624 may provide electrical connection to the first electrodes of any number of MIM capacitors in this way. In other examples, backside conductive layer 624 contacts the conductive plug 606 beneath only one MIM capacitor structure. Backside conductive layer 624 may include any suitable conductive material, such as copper, tungsten, ruthenium, molybdenum, or cobalt.

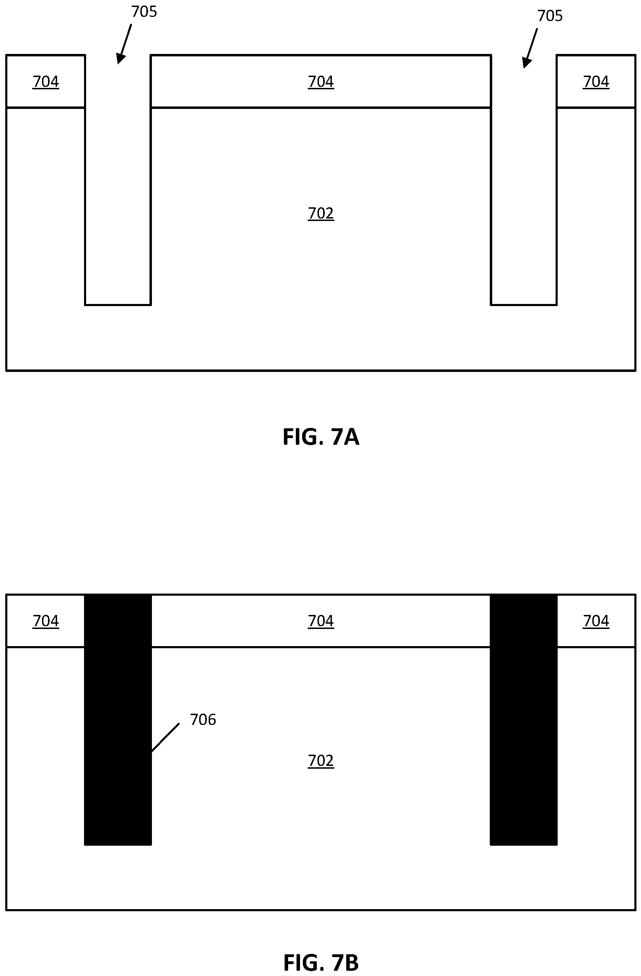

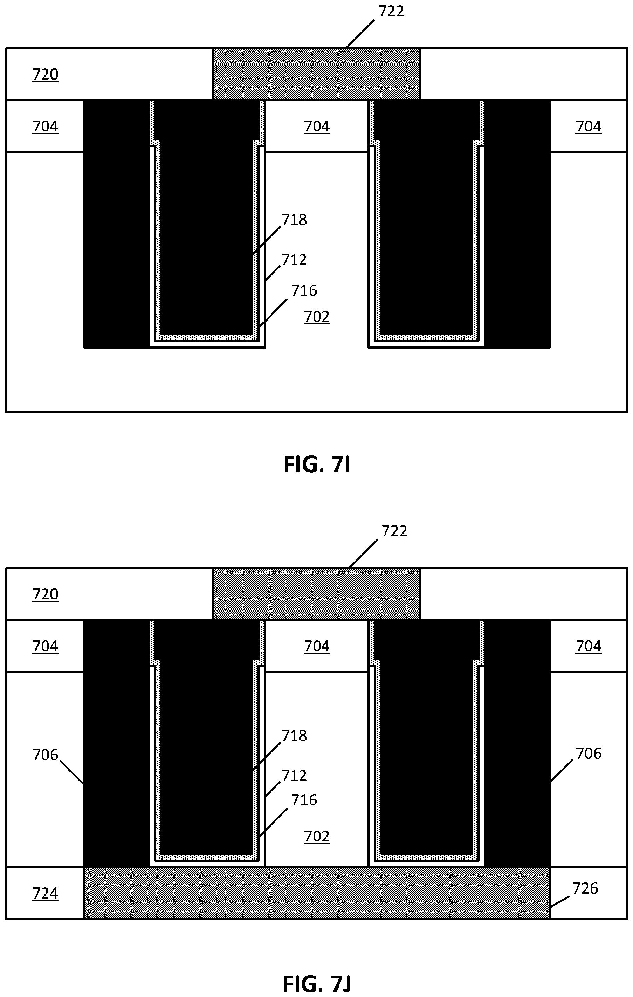

Figures 7A - 7J are cross-sectional views that collectively illustrate an example process for forming a portion of an integrated circuit, in accordance with an embodiment of the present disclosure. Each figure shows an example structure that results from the process flow up to that point in time, so the depicted structure evolves as the process flow continues, culminating in the MIM capacitor structure shown in Figure 7J, which is similar to the structure illustrated in Figure 4. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 7A is a cross sectional view taken through a portion of a device layer 702. Device layer 702 may be substantially similar to device region 101 discussed above with reference to Figure 1. Accordingly, the illustrated portion of device layer 702 may be away from the semiconductor devices and may include any suitable semiconductor material. According to some embodiments, a dielectric layer 704 is provided on a top surface of device layer 702. Dielectric layer 704 may include any suitable dielectric material, such as silicon dioxide, silicon nitride, or silicon oxynitride.

According to some embodiments, recesses 705 are etched through an entire thickness of dielectric layer 704 and through at least a portion of device layer 702. An RIE process may be used along with suitable lithography techniques to pattern and etch recesses 705. According to some embodiments, recesses 705 may be trenches that extend into and out of the page. Recesses 705 may have a depth of, for example, between about 100 nm and about 200 nm. Any number of recesses 705 may be provided depending on the number of desired TSVs.

Figure 7B is a cross sectional view of the structure depicted in Figure 7A, after the formation of TSVs 706 within recesses 705, according to some embodiments. Any number of conductive materials may be formed within recesses 705 and may fill an entire volume of recesses 705. TSVs 706 may include any suitable conductive material, such as tungsten, ruthenium, molybdenum, or cobalt and may have a height between about 75 nm and about 300 nm. Other examples may be configured differently. TSVs 706 may extend through an entire thickness of device layer 702 or only through a partial thickness of device layer 702. In some examples, a dielectric liner is first formed within recesses 705 to separate TSVs 706 from device layer 702. The dielectric liner may include silicon dioxide or silicon nitride, to name a few examples.

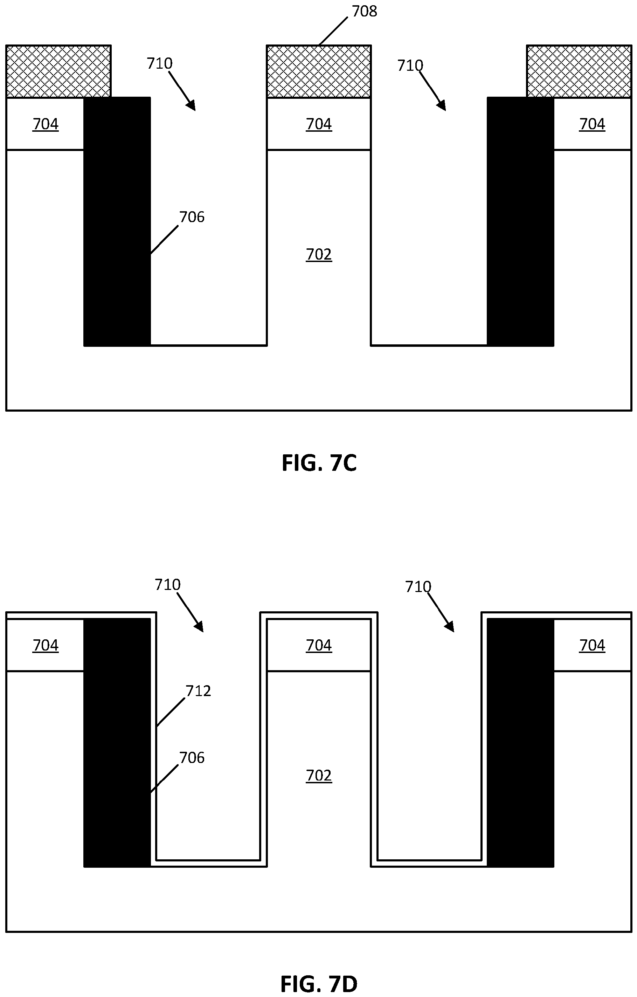

Figure 7C is a cross sectional view of the structure depicted in Figure 7B, after formation of a mask structure 708 and subsequent etching to form recesses 710 adjacent to TSVs 706, according to some embodiments. Mask structure 708 may be any suitable dielectric material or lithographic masking material, such as photoresist or CHM. According to some embodiments, mask structure 708 is patterned to expose portions of dielectric layer 704 directly adjacent to one or more TSVs 706. An RIE process may be used to etch through any exposed materials not protected by mask structure 708. Accordingly, the etch may form recesses 710 through device layer 702. By tuning the selectivity of the etch, recesses 710 may be self-aligned with a sidewall of corresponding TSVs 706. Accordingly, the etching process may remove exposed silicon-based materials while removing little to none of the exposed metal materials from TSV 706. According to some embodiments, recesses 710 are formed to a depth that is substantially equal (e.g., within 5 nm) to a height of TSV 706.

Figure 7D is a cross sectional view of the structure depicted in Figure 7C, after formation of a first electrode 712, according to some embodiments. First electrode 712 may include tungsten that is deposited using any one of electroplating, electroless plating, CVD, ALD, or PECVD, to name a few examples. Any other suitable conductive materials may be used as well (e.g., aluminum, ruthenium, cobalt, molybdenum). According to some embodiments, first electrode 712 includes titanium nitride. First electrode 712 may be deposited directly on all surfaces within recesses 710 as well as on the top surface of dielectric layer 704. First electrode 712 is deposited directly on a sidewall of TSV 706 within recess 710, according to some embodiments. In some examples, first electrode 712 has a thickness between about 5 nm and about 20 nm.

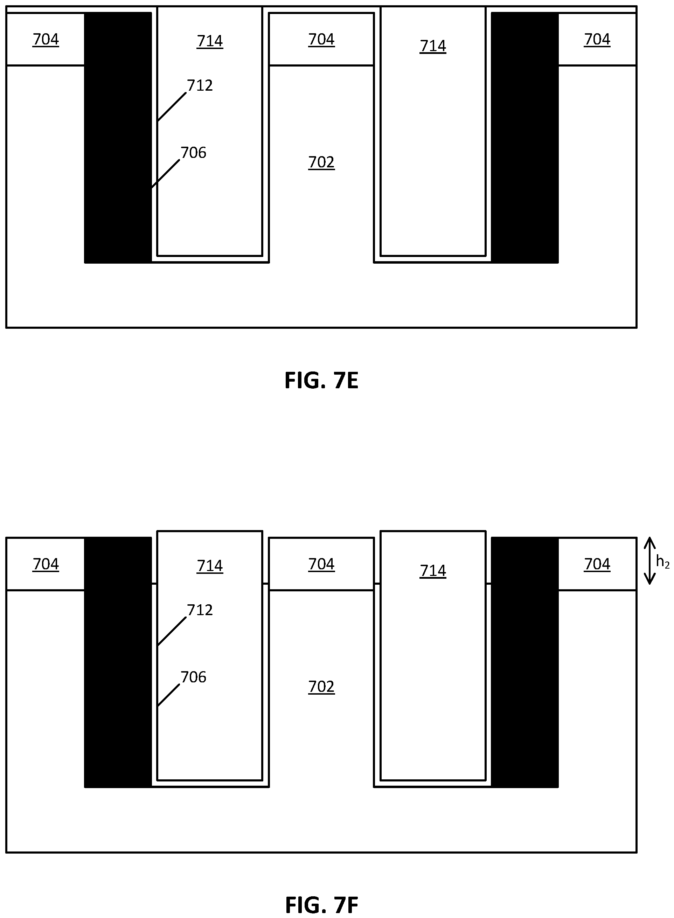

Figure 7E is a cross sectional view of the structure depicted in Figure 7D, after the formation of a filler material 714 within a remaining volume of recesses 710, according to some embodiments. Filler material 714 may be any flowable dielectric material or CHM, to name a few examples. According to some embodiments, filler material 714 fills recesses 710 and is polished back to remove any excess filler material 714 from outside of recesses 710. Thus, a top surface of filler material 714 may be polished until it is substantially coplanar with a top surface of first electrode 712 over dielectric layer 704.

Figure 7F is a cross sectional view of the structure depicted in Figure 7E, after an etching process is performed to recess first electrode 712 by a height h₂ below a top surface of dielectric layer 704, according to some embodiments. Any suitable selective isotropic and/or directional etching process may be used to remove exposed portions of first electrode 712, which includes removing a top portion of first electrode 712 along the sidewall surface of filler material 714. According to some embodiments, first electrode 712 may be recessed by a height h₂ between about 10 nm and about 50 nm.

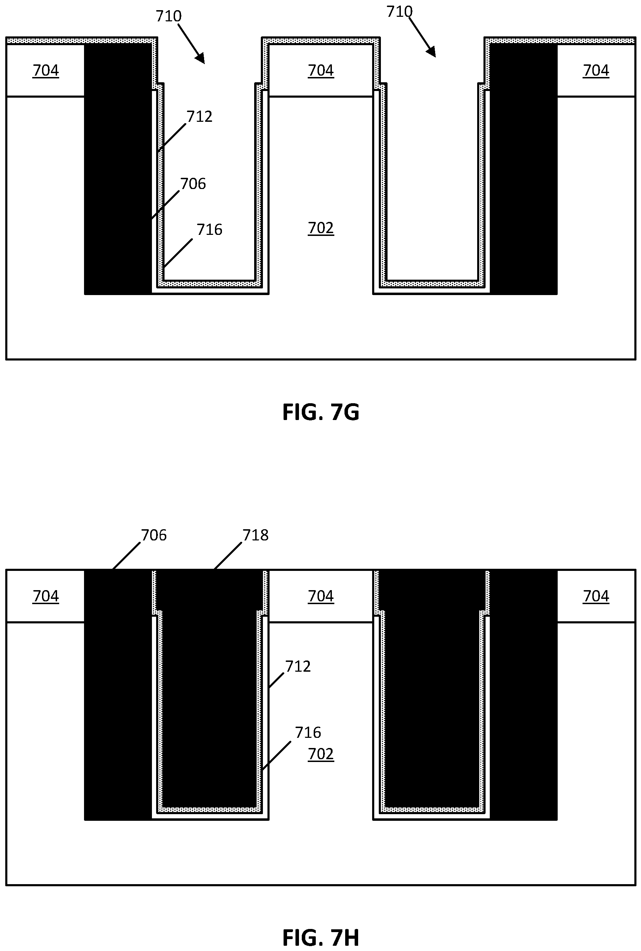

Figure 7G is a cross sectional view of the structure depicted in Figure 7F, after the removal of filler material 714 and the subsequent formation of capacitor dielectric 716, according to some embodiments. Capacitor dielectric 716 may represent any number of deposited dielectric layers. In some examples, capacitor dielectric 716 includes a layer of hafnium oxide or any other suitable high-k dielectric material. Capacitor dielectric 716 may be conformally deposited using any suitable dielectric deposition technique, such as CVD, PECVD, ALD, or spin-on dielectric, and may have a thickness between about 5 nm and about 20 nm.

According to some embodiments, capacitor dielectric 716 follows first electrode 712 along the surfaces within recesses 710 and over the recessed end of first electrode 712. Accordingly, capacitor dielectric 716 may "pinch off" first electrode 712 as it extends along the sidewalls of recess 710. According to some embodiments, capacitor dielectric 716 continues to extend along the sidewalls of recess 710 above first electrode 712 and over the top surface of dielectric layer 704. Capacitor dielectric 716 may extend between any number of adjacent recesses 710 in this way.

Figure 7H is a cross sectional view of the structure depicted in Figure 7G, after the formation of a second electrode 718, according to some embodiments. Second electrode 718 may include any number of conductive materials, such as a conductive liner and a conductive fill on the conductive liner. In other examples, second electrode 718 has only a conductive fill (with no liner). Any suitable conductive materials may be used for either or both the conductive fill and conductive liner, such as tungsten, ruthenium, molybdenum, or cobalt. In some embodiments, second electrode 718 includes titanium nitride. Second electrode 718 may substantially fill the remaining volume of recess 710 between capacitor dielectric 716. According to some embodiments, second electrode 718 is separated from first electrode 712 by capacitor dielectric 716 along all of first electrode 712. A top surface of second electrode 718 may be polished until it is substantially coplanar with a top surface of dielectric layer 704.

Figure 7I is a cross sectional view of the structure depicted in Figure 7H, after the formation of a topside dielectric layer 720 over dielectric layer 704, and a topside conductive layer 722, according to some embodiments. Topside dielectric layer 720 may be any suitable dielectric material, such as silicon dioxide, silicon nitride, or silicon oxynitride. In some examples, topside dielectric layer 720 includes the same dielectric material as dielectric layer 704.

According to some embodiments, topside conductive layer 722 is provided through topside dielectric layer 720 to make electrical contact with second electrode 718. In the illustrated example, topside conductive layer 722 extends to contact the second electrode 718 of two adjacent MIM capacitors. In other examples, topside conductive layer 722 contacts the second electrode 718 of only one MIM capacitor. Topside conductive layer 722 may include any suitable conductive material, such as copper, tungsten, ruthenium, molybdenum, or cobalt.

Figure 7J is a cross sectional view of the structure depicted in Figure 7I, after the removal of a backside portion of the substrate and subsequent formation of a backside dielectric layer 724 and backside conductive layer 726, according to some embodiments. The backside of the substrate may be removed using any number of or combination of techniques such as dry etching, wet etching, polishing, or grinding. In some examples, the backside of the substrate is polished or grinded down until the lower surface of TSVs 706 and/or first electrode 712 is exposed.

According to some embodiments, backside dielectric layer 724 may be formed on the bottom surface of device layer 702 and on the exposed bottom surface of TSVs 706 and/or first electrode 712. Backside dielectric layer 724 may be any suitable dielectric material, such as silicon dioxide, silicon nitride, or silicon oxynitride. According to some embodiments, backside conductive layer 726 is provided through backside dielectric layer 724 to make electrical contact with one or more TSVs 706 and/or first electrode 712. In the illustrated example, backside conductive layer 726 extends to contact more than one TSV 706. In some embodiments, backside conductive layer 726 contacts the first electrode 712 of any number of adjacent MIM capacitors. Whether contacting TSV 706 or first electrode 712, backside conductive layer 726 provides electrical connection to the first electrodes of any number of MIM capacitors, according to some embodiments. In other examples, backside conductive layer 726 contacts only one TSV 706 or contacts the first electrode of only one MIM capacitor. Backside conductive layer 726 may include any suitable conductive material, such as copper, tungsten, ruthenium, molybdenum, or cobalt.

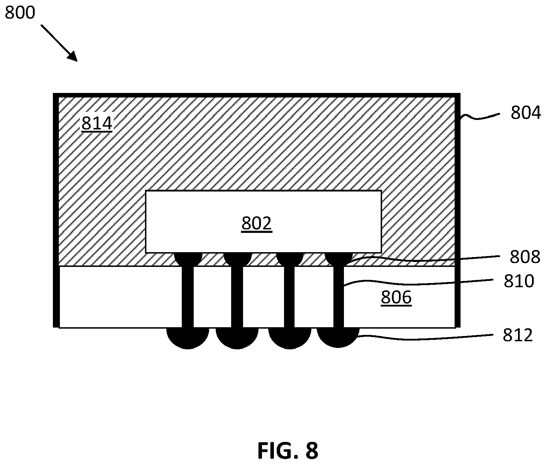

Figure 8 illustrates an example embodiment of a chip package 800, in accordance with an embodiment of the present disclosure. As can be seen, chip package 800 includes one or more dies 802. One or more dies 802 may include at least one integrated circuit having a structure as described in any of the aforementioned embodiments. One or more dies 802 may include any other circuitry used to interface with other devices formed on the dies, or other devices connected to chip package 800, in some example configurations.

As can be further seen, chip package 800 includes a housing 804 that is bonded to a package substrate 806. The housing 804 may be any standard or proprietary housing, and may provide, for example, electromagnetic shielding and environmental protection for the components of chip package 800. The one or more dies 802 may be conductively coupled to a package substrate 806 using connections 808, which may be implemented with any number of standard or proprietary connection mechanisms, such as solder bumps, ball grid array (BGA), pins, or wire bonds, to name a few examples. Package substrate 806 may be any standard or proprietary package substrate, but in some cases includes a dielectric material having conductive pathways (e.g., including conductive vias and lines) extending through the dielectric material between the faces of package substrate 806, or between different locations on each face. In some embodiments, package substrate 806 may have a thickness less than 1 millimeter (e.g., between 0.1 millimeters and 0.5 millimeters), although any number of package geometries can be used. Additional conductive contacts 812 may be disposed at an opposite face of package substrate 806 for conductively contacting, for instance, a printed circuit board (PCB). One or more vias 810 extend through a thickness of package substrate 806 to provide conductive pathways between one or more of connections 808 to one or more of contacts 812. Vias 810 are illustrated as single straight columns through package substrate 806 for ease of illustration, although other configurations can be used (e.g., damascene, dual damascene, through-silicon via, or an interconnect structure that meanders through the thickness of substrate 806 to contact one or more intermediate locations therein). In still other embodiments, vias 810 are fabricated by multiple smaller stacked vias, or are staggered at different locations across package substrate 806. In the illustrated embodiment, contacts 812 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 812, to inhibit shorting.

In some embodiments, a mold material 814 may be disposed around the one or more dies 802 included within housing 804 (e.g., between dies 802 and package substrate 806 as an underfill material, as well as between dies 802 and housing 804 as an overfill material). Although the dimensions and qualities of the mold material 814 can vary from one embodiment to the next, in some embodiments, a thickness of mold material 814 is less than 1 millimeter. Example materials that may be used for mold material 814 include epoxy mold materials, as suitable. In some cases, the mold material 814 is thermally conductive, in addition to being electrically insulating.

### Example System

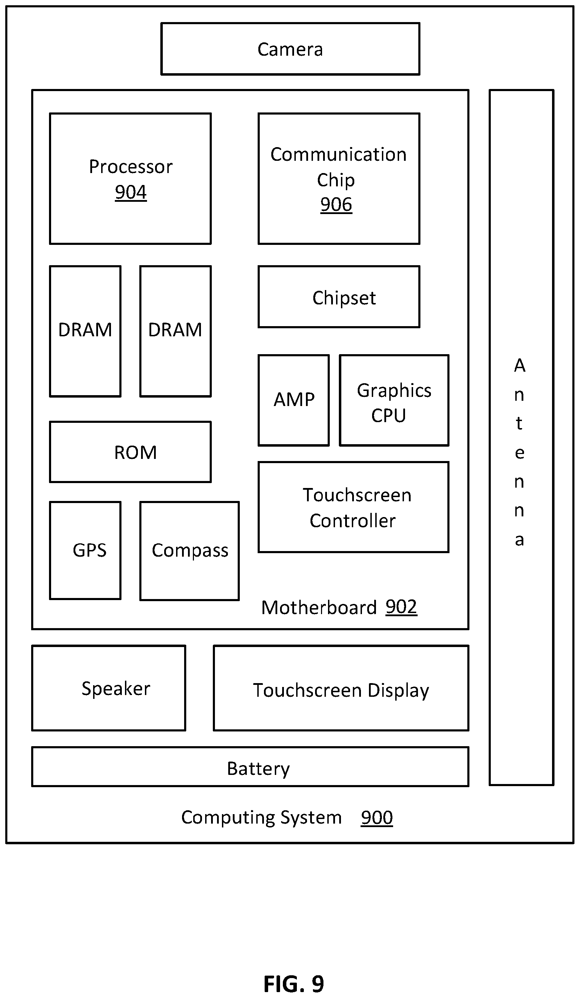

FIG. 9 is an example computing system implemented with one or more of the integrated circuit structures as disclosed herein, in accordance with some embodiments of the present disclosure. As can be seen, the computing system 900 houses a motherboard 902. The motherboard 902 may include a number of components, including, but not limited to, a processor 904 and at least one communication chip 906, each of which can be physically and electrically coupled to the motherboard 902, or otherwise integrated therein. As will be appreciated, the motherboard 902 may be, for example, any printed circuit board (PCB), whether a main board, a daughterboard mounted on a main board, or the only board of system 900, etc.

Depending on its applications, computing system 900 may include one or more other components that may or may not be physically and electrically coupled to the motherboard 902. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 900 may include one or more integrated circuit structures or devices configured in accordance with any of the embodiments disclosed herein (e.g., a module including an integrated circuit having one or more MIM capacitors integrated with via structures). In some embodiments, multiple functions can be integrated into one or more chips (e.g., for instance, note that the communication chip 906 can be part of or otherwise integrated into the processor 904).

The communication chip 906 enables wireless communications for the transfer of data to and from the computing system 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing system 900 includes an integrated circuit die packaged within the processor 904. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 906 also may include an integrated circuit die packaged within the communication chip 906. In accordance with some such example embodiments, the integrated circuit die of the communication chip includes one or more semiconductor devices as variously described herein. As will be appreciated in light of this disclosure, note that multi-standard wireless capability may be integrated directly into the processor 904 (e.g., where functionality of any chips 906 is integrated into processor 904, rather than having separate communication chips). Further note that processor 904 may be a chip set having such wireless capability. In short, any number of processor 904 and/or communication chips 906 can be used. Likewise, any one chip or chip set can have multiple functions integrated therein.

In various implementations, the computing system 900 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 900 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a plurality of semiconductor devices in a first region of a substrate, one or more conductive vias extending through a thickness of the substrate in a second region of the substrate, and a capacitor around a via of the one or more conductive vias. The capacitor includes a first electrode contacting a sidewall of the via, a dielectric layer on the first electrode, and a second electrode on the dielectric layer and extending along a top surface of a portion of the substrate. The integrated circuit also includes a conductive contact arranged to contact the second electrode.

Example 2 includes the integrated circuit of Example 1, wherein the capacitor extends along substantially an entire height of the via.

Example 3 includes the integrated circuit of Example 1 or 2, wherein the via has a height between about 10 micrometers and about 75 micrometers.

Example 4 includes the integrated circuit of any one of Examples 1-3, wherein the via comprises copper or tungsten.

Example 5 includes the integrated circuit of any one of Examples 1-4, further comprising a conductive layer beneath a backside of the substrate, wherein the conductive layer contacts the via.

Example 6 includes the integrated circuit of any one of Examples 1-5, wherein the via is a first via and the capacitor is a first capacitor, wherein the integrated circuit further comprises a second capacitor around a second via adjacent to the first via.

Example 7 includes the integrated circuit of Example 6, wherein the second capacitor comprises a third electrode contacting a sidewall of the second via, a second capacitor dielectric on the third electrode, and a fourth electrode on the second capacitor dielectric and extending along a top surface of a portion of the substrate. The fourth electrode is coupled to the second electrode.

Example 8 includes the integrated circuit of Example 7, wherein the second electrode and the fourth electrode are a same conductive layer that extends along the top surface of the portion of the substrate and along a height of each of the first via and the second via.

Example 9 includes the integrated circuit of any one of Examples 1-8, wherein the conductive contact extends into a portion of the substrate.

Example 10 includes the integrated circuit of any one of Examples 1-9, wherein the first electrode and the second electrode comprise titanium and nitrogen or comprise ruthenium.

Example 11 includes the integrated circuit of any one of Examples 1-10, wherein the substrate is a silicon substrate and the capacitor is around a through silicon via (TSV).

Example 12 includes the integrated circuit of any one of Examples 1-10, wherein the substrate is a semiconductor substrate and the capacitor is around a through-semiconductor via (TSV).

Example 13 includes the integrated circuit of any one of Examples 1-10, wherein the capacitor is around a via that passes through a dielectric layer of the substrate.

Example 14 is a printed circuit board comprising the integrated circuit of any one of Examples 1-13.

Example 15 is an integrated circuit that includes a plurality of semiconductor devices in a first region of a device layer, a dielectric layer on a top surface of the device layer, and a capacitor extending through the dielectric layer and the device layer in a second region of the device layer. The capacitor includes a first electrode along an outer edge of the capacitor, a dielectric layer on the first electrode and extending above and over the first electrode, and a second electrode on the dielectric layer and extending above the first electrode. The integrated circuit also includes a conductive plug beneath the first electrode and directly contacting the first electrode.

Example 16 includes the integrated circuit of Example 15, wherein the first electrode is recessed below a top surface of the dielectric layer.

Example 17 includes the integrated circuit of Example 16, wherein the first electrode is recessed by between about 10 nm and about 30 nm below the top surface of the dielectric layer.

Example 18 includes the integrated circuit of any one of Examples 15-17, wherein a width of the top surface of the conductive plug is substantially equal to a width of a bottom surface of the first electrode.

Example 19 includes the integrated circuit of any one of Examples 15-18, wherein the conductive plug comprises tungsten.

Example 20 includes the integrated circuit of any one of Examples 15-19, wherein the first electrode and the second electrode comprise titanium and nitrogen or comprise ruthenium.

Example 21 includes the integrated circuit of any one of Examples 15-20, further comprising a backside conductive layer beneath the conductive plug and directly contacting the conductive plug.

Example 22 includes the integrated circuit of Example 21, wherein the backside conductive layer contacts more than one conductive plug associated with more than one capacitor.

Example 23 includes the integrated circuit of any one of Examples 15-22, further comprising a topside conductive layer that contacts the second electrode.

Example 24 includes the integrated circuit of Example 23, wherein the topside conductive layer contacts more than one second electrode associated with more than one capacitor.

Example 25 is a printed circuit board comprising the integrated circuit of any one of Examples 15-24.

Example 26 is an integrated circuit that includes a plurality of semiconductor devices in a first region of a device layer, a dielectric layer on a top surface of the device layer, a via extending through an entire thickness of the dielectric layer and the device layer in a second region of the device layer, and a capacitor extending through the dielectric layer and the device layer and adjacent to the via. The capacitor includes a first electrode along an outer edge of the capacitor and contacting a sidewall of the via, a dielectric layer on the first electrode and extending above and over the first electrode, and a second electrode on the dielectric layer and extending above the first electrode.

Example 27 includes the integrated circuit of Example 26, wherein the first electrode is recessed below a top surface of the dielectric layer.

Example 28 includes the integrated circuit of Example 27, wherein the first electrode is recessed by between about 10 nm and about 30 nm below the top surface of the dielectric layer.

Example 29 includes the integrated circuit of any one of Examples 26-28, wherein the first electrode does not extend along an entire height of the via.

Example 30 includes the integrated circuit of any one of Examples 26-29, wherein the via comprises tungsten.

Example 31 includes the integrated circuit of any one of Examples 26-30, wherein the first electrode and the second electrode comprise titanium and nitrogen or comprise ruthenium.

Example 32 includes the integrated circuit of any one of Examples 26-31, further comprising a backside conductive layer beneath the via and directly contacting the via and/or the first electrode.

Example 33 includes the integrated circuit of Example 32, wherein the backside conductive layer contacts more than one via and/or more than one first electrodes associated with more than one capacitor.

Example 34 includes the integrated circuit of any one of Examples 26-33, further comprising a topside conductive layer that contacts the second electrode.

Example 35 includes the integrated circuit of Example 34, wherein the topside conductive layer contacts more than one second electrode associated with more than one capacitor.

Example 36 is a printed circuit board that includes the integrated circuit of any one of Examples 26-35.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit, comprising:
a plurality of semiconductor devices in a first region of a substrate;
one or more conductive vias extending through a thickness of the substrate in a second region of the substrate;
a capacitor around a via of the one or more conductive vias, wherein the capacitor comprises
a first electrode contacting a sidewall of the via,
a capacitor dielectric on the first electrode, and
a second electrode on the capacitor dielectric and extending along a top surface of a portion of the substrate; and
a conductive contact arranged to contact the second electrode.

2. The integrated circuit of claim 1, wherein the capacitor extends along substantially an entire height of the via.

3. The integrated circuit of claim 1 or 2, wherein the via has a height between about 10 micrometers and about 75 micrometers.

4. The integrated circuit of any one of claims 1 through 3, wherein the via comprises copper or tungsten.

5. The integrated circuit of any one of claims 1 through 4, further comprising a conductive layer beneath a backside of the substrate, wherein the conductive layer contacts the via.

6. The integrated circuit of any one of claims 1 through 5, wherein the via is a first via and the capacitor is a first capacitor, wherein the integrated circuit further comprises a second capacitor around a second via adjacent to the first via.

7. The integrated circuit of claim 6, wherein the second capacitor comprises:
a third electrode contacting a sidewall of the second via;
a second capacitor dielectric on the third electrode; and
a fourth electrode on the second capacitor dielectric and extending along a top surface of a portion of the substrate, wherein the fourth electrode is coupled to the second electrode.

8. The integrated circuit of claim 7, wherein the second electrode and the fourth electrode are a same conductive layer that extends along the top surface of the portion of the substrate and along a height of each of the first via and the second via.

9. The integrated circuit of any one of claims 1 through 8, wherein the conductive contact extends into a portion of the substrate.

10. The integrated circuit of any one of claims 1 through 9, wherein the first electrode and the second electrode comprise titanium and nitrogen or comprise ruthenium.

11. The integrated circuit of any one of claims 1 through 10, wherein the substrate is a silicon substrate and the capacitor is around a through silicon via (TSV).

12. The integrated circuit of any one of claims 1 through 10, wherein the substrate is a semiconductor substrate and the capacitor is around a through-semiconductor via (TSV).

13. The integrated circuit of any one of claims 1 through 10, wherein the capacitor is around a via that passes through a dielectric layer of the substrate.

14. A printed circuit board comprising the integrated circuit of any one of claims 1 through 13.
